# EUROPEAN PATENT APPLICATION

(11) **EP 4 518 588 A1**
(43) Date of publication of application: **05.03.2025**
(21) Application number: 24197583.8
(22) Date of filing: 30.08.2024
(51) Int. Cl.: H05K 1/02, H05K 3/34, H05K 1/11

(54) **COMPACT POWER ELECTRONICS DEVICE FOR CONTROLLING ELECTRIC VEHICLE BATTERIES**

(30) Priority: 01.09.2023 US 202318459665
(71) Applicant: Volvo Car Corporation, 405 31 Göteborg (SE)
(72) Inventor: FORSSELL, Jonas, 40531 Göteborg (SE); SINGH, Aditya Pratap, 40531 Göteborg (SE); LINDQVIST, David, 40531 Göteborg (SE); BJÖRKHOLTZ, Jonas, 40531 Göteborg (SE)
(74) Representative: Maiwald GmbH

(57) **Abstract**

Compact designs for a printed circuit board (PCB) device of a smartcell battery system are provided. The design includes a number of features, including a scalable, high performance power module. The power module includes a number of power switches (e.g., metal oxide semiconductor field effect transistors (MOSFETs)), that have low resistance which can control very high currents of a direct to direct (DCDC) converter and an H-bridge of the PCB. The power module is sandwiched between the input and output busbars positioned on opposite surfaces of the primary, planar substrate of the PCB in order to create the shortest possible current transfer distance.

## Description

### TECHNICAL FIELD

The subject disclosure relates to electric and/or hybrid electric vehicle drive technologies, and more particularly to a compact power electronics device for controlling batteries of an electric and/or hybrid vehicle.

### BACKGROUND

Currently, Electric vehicles (EVs) are becoming increasingly popular as a more sustainable mode of transportation. The electric vehicle battery management system (BMS) is a critical component in the successful operation of an electric vehicle. It plays a key role in ensuring the safety, performance, and reliability of the electric vehicles battery system. Printed circuit boards (PCBs) are an integral part of this system as they house the system's various components, such as sensors and controllers, and provide interconnectivity between them. With the demand for optimized BMS systems and energy control in the EV, new PCB technologies that serve this demand are needed.

### SUMMARY

The following presents a summary to provide a basic understanding of one or more embodiments of the invention. This summary is not intended to identify key or critical elements or delineate any scope of the particular embodiments or any scope of the claims. Its sole purpose is to present concepts in a simplified form as a prelude to the more detailed description that is presented later. In one or more embodiments described herein, compact power electronics PCB technologies for controlling batteries of an electric and/or hybrid vehicle are provided.

In an embodiment, a compact PCB device for controlling batteries of an electric vehicle is provided. The PCB device comprises a direct current to direct current (DCDC) converter formed on a substrate, the DCDC converter comprising a primary winding having a planar geometry and formed on a first surface of the substrate, a secondary winding having a planar geometry and formed on a second surface of the substrate opposite the first surface, a transformer core formed around the primary winding and the secondary winding.

In one or more implementations, the DCDC converter comprises an LLC resonant converter, wherein the primary winding comprises a first inductor of the LLC resonant converter and the secondary winding comprises a second inductor of the LLC resonant converter, and wherein the primary winding and the secondary winding are respectively configured to generate a defined amount of leakage inductance by the LLC resonant converter without usage of a third inductor. For example, in some implementations the primary winding, the secondary winding and the substrate form a stacked, three-layer structure comprising the substrate sandwiched between the primary winding and the secondary winding, wherein the primary winding and the secondary winding are partially misaligned in a direction parallel to the first surface and the second surface, and wherein the defined amount of leakage inductance results from the primary winding and the secondary winding being partially misaligned. The defined amount of leakage inductance can also result from the transformer core being formed around only a portion of the primary winding and the secondary winding. For example, in some implementations, the transformer core can be defined by a distal end, a proximal end opposite the distal end, and a length that extends laterally from the distal end to the proximal end, and wherein portions of the primary winding and the secondary winding extend laterally beyond the proximal end and distal end of the transformer core in a direction parallel to the first surface and the second surface.

In various embodiments, the primary winding comprises a sheet of conductive metal patterned into a planar winding configuration and wherein the primary winding is soldered to the first surface of the substrate. In some embodiments, the substrate comprises a first substrate and wherein the secondary winding comprises traces formed on or within a second substrate formed on the second surface of the first substrate.

In some embodiments, The PCB device of claim 1, further comprises busbars formed on opposite surfaces of the substrate, the busbars comprising first busbars formed on the first surface of the substrate and second busbars formed on the second surface of the substrate, and a power module formed on the substrate sandwiched between the first busbars and the second busbars, the power module comprising a plurality of power switches that control flow electrical currents between the busbars. In various implementations of these embodiments, the plurality of power switches comprise at least two switches electrically connected to the primary winding that control switching operations of the DCDC converter. With these implementations, the second busbars can comprise an inlet busbar electrically connected to a first switch of the at least two switches and configured to feed an input electrical current to the primary winding via the first switch, and an outlet busbar electrically connected to a second switch of the at least two switches and configured to receive an output electrical current from the primary winding via the second switch. To this end, the first switch and the second switch can be sandwiched between a portion of the primary winding and respective portions of the inlet busbar and the outlet busbar, and wherein the at least two power switches are aligned with the portion of the primary winding and the respective portions of the inlet busbar and the outlet busbar in a direction perpendicular to the first surface and the second surface.

In some implementations, the PCB device further includes a row of capacitors formed on the second surface at a position aligned with the power module in the direction perpendicular to the first surface and the second surface, wherein a distal end of the row is aligned with the portion of the primary winding in the direction perpendicular to the first surface and the second surface, wherein the row of capacitors is electrically connected to the primary winding and is configured to provide a second input electrical current to the primary winding and further configured to perform a function of the PCB device disassociated with the DCDC converter.

In some implementations, the PCB device can include another row of capacitors formed on the second surface and electrically connected to a portion of the primary winding, wherein the row of capacitors is aligned with the portion of the primary winding in a direction perpendicular to the first surface and the second surface.

In another embodiment, a method comprises forming a DCDC converter on a substrate, comprising forming a primary winding having a planar geometry on a first surface of the substrate, forming a secondary winding having a planar geometry on a second surface of the substrate opposite the first surface, and forming a transformer core around the primary winding and the secondary winding. In some implementations, the DCDC converter comprises an LLC resonant converter, wherein the primary winding comprises a first inductor of the LLC resonant converter and the secondary winding comprises a second inductor of the LLC resonant converter, and wherein forming the DCDC converter comprises configuring the primary winding and the secondary winding to generate a defined amount of leakage inductance by the LLC resonant converter without usage of a third inductor.

In another embodiment, a device can comprise one or more battery cells, and a PCB device attached to the one or more battery cells. The PCB device can comprise a DCDC converter formed on a substrate and electrically connected to the one or more battery cells, the DCDC converter comprising a primary winding having a planar geometry and formed on a first surface of the substrate, a secondary winding having a planar geometry and formed on a second surface of the substrate opposite the first surface, a transformer core formed around the primary winding and the secondary winding.

In another embodiment, a compact PCB device for controlling batteries of an electric vehicle is provided. The PCB device can comprise busbars formed on opposite sides of a substrate, and a power module formed on the substrate sandwiched between the busbars and electrically connected to the busbars, the power module comprising power switches that control flow of an electrical current between the busbars. In some implementations, the power switches control the flow of the electrical current in a direction perpendicular to the opposite sides of the substrate. In some implementations, the substrate comprises electrical connectors formed within a thickness of the substrate and exposed on the opposite sides of the substrate, wherein the power switches are formed on the substrate at positions directly above or directly below the electrical connectors, and wherein the electrical connectors connect respective ones of the power switches to the busbars.

In another embodiment, a method can comprise forming a power module on the substrate, the power module comprising power switches, forming busbars on opposite sides of the substrate and the power module, and electrically connecting the power switches to the busbars. In an aspect, forming the busbars comprises soldering the busbars to the opposite sides of the substrate with the power module sandwiched between the busbars. In some implementations, the method further comprises forming electrical connectors within a thickness of the substrate and exposed on the opposite sides of the substrate, and wherein forming the power module comprises positioning the power switches on the substrate at positions directly above or directly below the electrical connectors.

In some implementations the substrate comprises a first substrate and the power module comprises the power switches embedded within a second substrate. With these implementations, forming the power module on the substrate comprises soldering the second substrate to first substrate. Soldering the second substrate to the first substrate can further comprise soldering the second substrate to a first side of the first substrate, and wherein forming the busbars comprises soldering one or more first busbars to the second substrate, and soldering one or more second busbars to a second side of the first substrate opposite the first side. In other implementations, forming the power module comprises separately soldering at least some of the power switches to the substrate.

In another embodiment, a device can comprise one or more battery cells, and a PCB device attached to the one or more battery cells. The PCB device can comprise busbars formed on opposite sides of a substrate, wherein at least one of the busbars is electrically connected to the one or more battery cells. The PCB device further comprises a power module formed on the substrate sandwiched between the busbars and electrically connected to the busbars, the power module comprising power switches that control flow of an electrical current between the busbars.

### DESCRIPTION OF THE DRAWINGS

One or more exemplary embodiments are described below in the Detailed Description section with reference to the following drawings.
FIG. 1 illustrates an example smartcell battery system that supplies power to one or more electrical systems of an electric vehicle in accordance with one or more embodiments described herein.
FIG. 2A illustrates an example battery cell unit of a smartcell battery system in accordance with one or more embodiments described herein.
FIG. 2B illustrates another illustrates example battery cell unit in accordance with one or more embodiments described herein.
FIG. 3 illustrates a simplified circuit diagram of an example direct to direct (DCDC) converter in accordance with one or more embodiments described herein.
FIG. 4 illustrates a top surface view of an example printed circuit board (PCB) device adapted for connecting to a battery cell unit in accordance with one or more embodiments described herein.
FIG. 5A illustrates an exploded view of an example PCB device in accordance with one or more first embodiments described herein.
FIG. 5B illustrates an exploded view of an example PCB device in accordance with one or more second embodiments described herein.
FIG. 6 illustrates a top surface view of an example PCB device with the alternating current (AC) busbars removed, in accordance with one or more embodiments described herein.
FIG. 7 illustrates a bottom surface view of an example PCB device in accordance with one or more embodiments described herein.
FIG. 8 illustrates a bottom surface view of an example PCB device with the DC busbars removed, in accordance with one or more embodiments described herein.
FIG. 9 illustrates a side view of an example PCB device in accordance with one or more embodiments described herein.
FIGs. 10A and 10B illustrate side views of an example PCB device with the primary substrate removed, in accordance with one or more embodiments described herein.
FIGs. 11A and 11B illustrate isolated views of the primary and secondary windings in accordance with one or more embodiments described herein.
FIGs. 12A-12D illustrate different configuration of the primary and secondary windings in accordance with one or more embodiments described herein.
FIGs. 13A and 13B illustrate cross-sectional views of an example PCB device in accordance with one or more embodiments described herein.
FIG. 14 illustrates an example method for forming a compact direct current to direct current (DCDC) converter on a PCB device in accordance with one or more embodiments described herein.
FIG. 15 illustrates another example method for forming a compact DCDC converter on a PCB device in accordance with one or more embodiments described herein.
FIG. 16 illustrates another example method for forming a compact DCDC converter on a PCB device in accordance with one or more embodiments described herein.
FIG. 17 illustrates an example method for forming a compact PCB device comprising an embedded power module in accordance with one or more embodiments described herein.
FIG. 18 illustrates another example method for forming a compact PCB device comprising an embedded power module in accordance with one or more embodiments described herein.
FIG. 19 illustrates another example method for forming a compact PCB device comprising an embedded power module in accordance with one or more embodiments described herein.

### DETAILED DESCRIPTION

The following detailed description is merely illustrative and is not intended to limit embodiments and/or application or uses of embodiments. Furthermore, there is no intention to be bound by any expressed or implied information presented in the preceding Background or Summary sections, or in the Detailed Description section.

In one or more embodiments described herein, PCB technologies for controlling batteries of an electric and/or hybrid vehicle are provided. The disclosed PCB technologies are particularly directed to PCB devices for controlling operations of battery cells of a smartcell battery system used to supply power to one or electrical machines (e.g., motors) and/or electrical systems of an electric vehicle.

A smartcell battery system aims to remove large and costly parts from a conventional drivetrain and use the batteries more efficiently. More particularly, a smartcell battery system is a multilevel inverter concept that aims to replace driveline components such as the conventional large inverter by integrating them into printed circuit boards (PCBs) connected to clusters of battery cells. These PCBs are connected wirelessly to a central controller that handles high level control. Each of the PCBs includes several power electronic elements that enable them to intelligently control and manage operations of the respective battery cells to which they are connected (e.g., rendering them "smart"). Further the PCBs enable the direct current (DC) output from a small battery cluster to be converted into an alternating current (AC) to control an electric motor through field-oriented control (FOC). The battery pack can be configured in a number of different ways depending on need for propulsion, utilization by other high and low voltage electrical systems of the vehicle and charging. Through changing the inverter switching to a smartcell system, the battery back can operate at double the voltage level of similar battery backs using a conventional inverter, resulting in a lower current with less losses. Further only the battery cells needed are activated instead of all batteries needing to be constantly active, thereby increasing efficiency.

The disclosed subject matter is particularly directed to a compact design for the PCB device that provides optimized utility while minimizing manufacturing costs. The design includes a number of features, including a direct current to direct current (DCDC) converter having a compact, low-cost format that can provide significant power output despite operating at low voltages. In one or more embodiments, the DCDC converter includes or corresponds to an LLC resonant converter, which provides higher switching frequencies and reduced switching losses as compared to other types of converters (e.g., flyback converters and/or forward converters). As opposed to using a prepackaged, standard DCDC converter, the disclosed techniques build the DCDC converter directly on the planar, primary substrate of the PCB in a manner that achieves better performance with fewer components and thus reduced cost. The DCDC converter includes a number of features, including but not limited to, a closed loop for the primary side winding, integrated leakage inductance, a planar integrated transformer, a modular exchangeable secondary side winding, and two variants of secondary side rectification depending on the desired output voltage. The components of the DCDC converter respectively have planar or substantially planar geometries that enable the DCDC converter to have a compact, planar geometry with an overall thickness of about 1.0 millimeters or less.

The PCB also incorporates a scalable, high performance power module. The power module includes a number of power switches (e.g., metal oxide semiconductor field effect transistors (MOSFETs), field effect transistors (FETs) and the like), that have low resistance (e.g., <0.5 mOhm) which control very high currents of the DCDC converter and the H-bridge of the PCB used to control the supply of the AC current to the motor (among other functions). A traditional power module includes a separate housing, isolation between power switches (e.g., metal oxide semiconductor field effect transistors (MOSFETs), field effect transistors (FETs) and the like) and high current connections to surrounding elements. In addition, traditional MOSFET package solutions do not provide the extremely low levels of resistance needed for the smartcell system, as traditional MOSFET package solutions add more resistance to the switch than the actual MOSFET itself.

The disclosed power module can contain a number of power switches which can be tailored depending on the power demands of the PCB. The power module is sandwiched between the input and output busbars positioned on opposite sides of the primary, planar substrate of the PCB in order to create the shortest possible current transfer distance. For example, the input and output busbars correspond to relatively large, substantially planar metal plates of a conducting metal (e.g., copper, aluminum, gold, etc.). As positioned on opposite sides of the planar primary substrate, the metal places are stacked to form opposing, parallel layers of metal on opposite sides of the planar primary substrate with the power module formed on the primary substrate and sandwiched between the opposing, parallel metal layers. With this configuration, the current path between the busbars is vertical through the power switches (e.g., perpendicular to the parallel planar surfaces of the busbars and the primary substrate). This helps to minimize switching inductance, maximize cooling and reduces the resistance to an absolute minimum. In addition, in accordance with some implementations of the smartcell battery system, the busbars are already water cooled in close vicinity to the power module. Thus, by sandwiching the power switches between the conducting busbars, the cooling of the busbars synergistically cools the power switches.

Although the disclosed techniques are described with respect to PCB devices as used for controlling operation of battery cells of an electric vehicle, the disclosed techniques can be extended to various other domains. In this regard, the disclosed PCB devices can be applied in association with utilization thereof to control and manage battery systems used to supply power to various other types of battery powered electrical systems besides those associated with electric vehicles and conventional vehicles.

One or more embodiments are now described with reference to the drawings, wherein like referenced numerals are used to refer to like elements throughout. It should be appreciated that the various structures depicted in the drawings are merely exemplary and may not be drawn to scale. In the following description, for purposes of explanation, numerous specific details are set forth in order to provide a more thorough understanding of the one or more embodiments. It is evident, however, in various cases, that the one or more embodiments can be practiced these specific details. In addition, certain elements may be left out of particular views for the sake of clarity and/or simplicity when explanations are not necessarily focused on the omitted elements. Moreover, the same or similar reference numbers used throughout the drawings are used to denote the same or similar features, elements, or structures, and thus, a detailed explanation of the same or similar features, elements, or structures will not be repeated for each of the drawings.

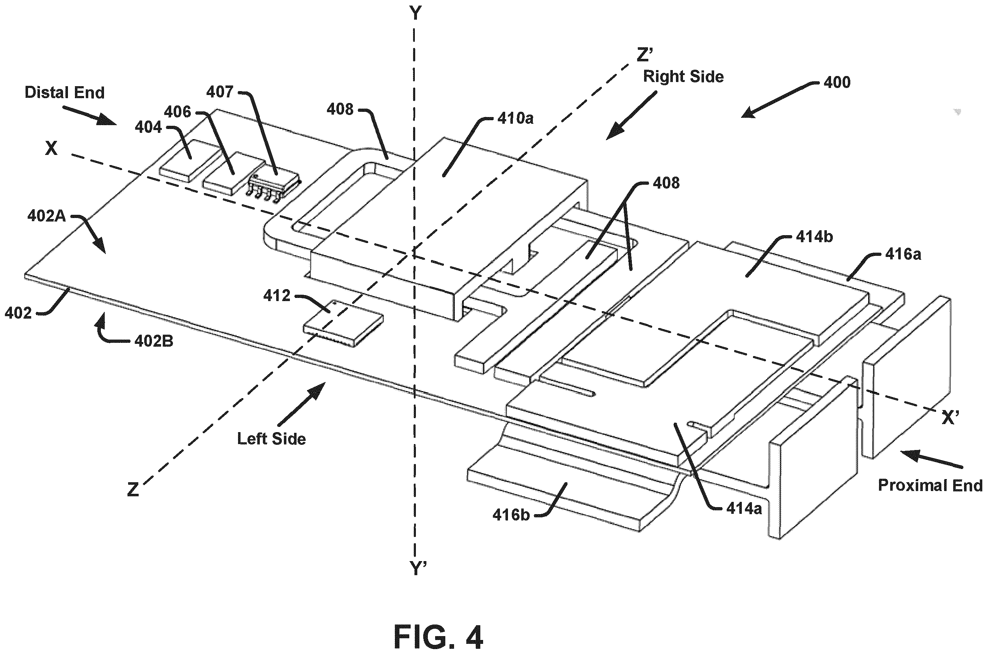

As used herein, unless otherwise specified, terms such as on, over, above, on top, positioned/formed on, or positioned/formed atop, and the like, means that a first component is present on a second component, wherein intervening components may be present between the first component and the second component. As used herein, terms such as upper, lower, top, bottom, above, below, aligned with, adjacent to, distal, proximal, right, left, vertical, horizontal, and derivatives thereof shall relate to the disclosed structures as oriented in the drawing figures relative to the X-X', Y-Y' and Z-Z' axis illustrated in FIG. 4. As used herein, unless otherwise specified, the terms "surface," "side," "end," and variations thereof, as used to describe a component of a PCB device assumes the side or end is defined by a physical element or structure having at least one surface.

The term "aligned with" is used herein to refer to a first component (or a portion thereof) being positioned relative to a second component (or a portion thereof) in a specified orientation or direction. In this regard, unless otherwise specified, the phrase "aligned with in a direction perpendicular to a (planar) surface of the substrate" means that the a straight line can be drawn from the first component to the second component that results in the straight line being perpendicular to the planar surface of the substrate. Unless otherwise specified, the phrase "aligned with in a direction parallel to the (planar) surface of the substrate" means that the a straight line can be drawn from the first component to the second component that results in the straight line being parallel to the planar surface of the substrate. As used herein, unless otherwise specified, the term directly used in connection with the terms above, below, beneath, next to, or the like, means that a first component and a second component are aligned with one another. As used herein, the term longitudinal (or vertical) means a direction parallel to the longitudinal axis of the PCB device, and the term lateral means a direction perpendicular to the longitudinal axis of the PCB device. In accordance with the PCB device(s) as described herein, the longitudinal axis (i.e., axis Y-Y' as shown in FIG. 4) runs perpendicular to the opposing top surface and bottom surface planar surface of the primary substrate.

It will be understood that when an element is referred to as being "connected" to or "coupled" to another element, it can describe one or more different types of coupling including, but not limited to, chemical coupling, communicative coupling, electrical coupling, electromagnetic coupling, operative coupling, optical coupling, physical coupling, thermal coupling, and/or another type of coupling.

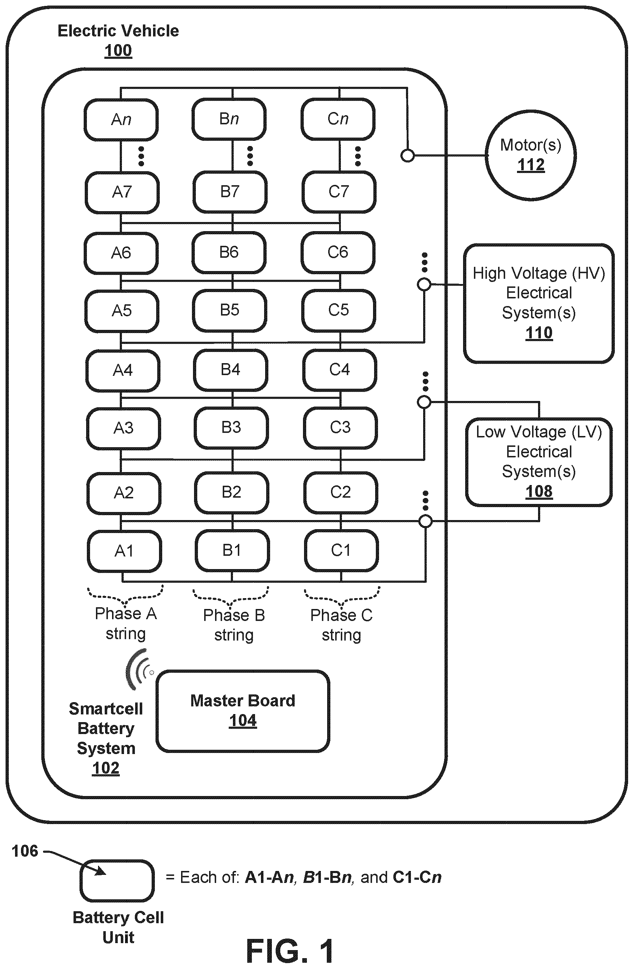

FIG. 1 illustrates an example smartcell battery system 102 that supplies power to one or more electrical systems of an electric vehicle 100 in accordance with one or more embodiments described herein. The one or more electrical systems can include one or more motors 112, one or more high voltage (HV) electrical systems 110 and/or one or more low voltage (LV) electrical systems 108. The one or more LV electrical systems 110 can include any type of electrical system associated with the electric vehicle 100 that typically consumes a DC input voltage less than about 50 volts (V) (e.g., 12V, 14V, 15V, 40V, 48V, etc.). Some examples of the LV electrical systems can include, but are not limited to, a power steering system, an autonomous driving system, an infotainment system, a navigation system, a backup camera system, and the like. The one or more HV electrical systems 110 can include any type of electrical system associated with the electric vehicle 100 that typically consumes a DC input voltage greater than about 50 V (e.g., 48V, 72V, 100 V, 400V, etc.), such as the heating, ventilation and air conditioning (HVAC) system, and others.

The one or more motors 112 (e.g., typically a single motor for a 2-wheel drive vehicle and two motors for a 4-wheel drive vehicle) can include any type of electric vehicle motor that is part the vehicle's powertrain or drive, including one or more DC motors and/or one or more AS motors. In various embodiments, the one or more motors 112 can include or correspond to a three-phase electric motor such as a permanent magnetic synchronous motor (PMSM). A PMSM is a synchronous machine that uses permanent magnets (PM) to generate a magnetic field instead of electromagnetic windings. The three-phase machine operates using a three-phase current system. The fundamental frequency of the supplying three-phase system also decides the rotor speed by controlling the rotating magneto-motive force (MMF). Together with the field of the PM rotor, the MMF generates the torque.

The rotor consists of the PM and three static coils are the stator windings. The stator windings are distributed 120° apart from the PM in the center. The stator windings can be represented as an inductance in series with a resistance. The three windings are described as phase A, phase B, and phase C with the phase currents *iₐ, i_{b}* and *i_{c}.* When the current runs through the static coils a magnetic field is generated according to Faraday's law, and a magnetic field is generated by the PM. When the electrical angle between the MMF of the stator and the rotor field is 90_{°}, the maximum torque is generated.

In conventional BEV systems, the three-phase current used for an AC motor such as PMSM is generated from a DC power supply by an inverter. In accordance with one or more embodiments of the disclosed techniques, the three-phase current is generated from the smartcell battery system 102 without the use of an inverter. To facilitate this end, the smartcell battery system 102 comprises a plurality of battery cells (not shown) arranged in three separate strings respectively corresponding to three different phases (e.g., Phase A string, Phase B string and Phase C string) that can provide the respective three phase currents of a three-phrase current used to drive the one or more motors 112.

In this regard, the smartcell battery system 102 includes a plurality of battery cell units 106 arranged in three separate strings respectively indicated as Phase A string, Phase B string and Phase C string. The battery cell units 106 associated with the Phase A string include units A1-A*n*, the battery cell units associated with the Phase B string include units B1-B*n*, and the battery cell units associated with the Phase C string include units C1-C*n*. The number of battery cell units "*n*" associated with each string can vary. For example, in some implementations, the number of battery cell units *n* included in each string is 96, making a total of 288 battery cell units 106 in the smartcell battery system 102. However, the number of battery cell units 106 included in the smartcell battery system 102 are not limited to this configuration and can be tailored to suit various usage scenarios.

Each battery cell unit 106 A1-An, B1-B*n*, and C1-C*n*, can include one or more battery cells and a PCB device that includes several power electronic elements that enable them to intelligently control and manage operations of the respective battery cells to which they are connected. Further the PCBs enable the DC output from a from respective battery cells to which they are connected to be converted into an AC to control one or more electric motors 112 through field-oriented control FOC. These PCBs are connected wirelessly to a master board 104 that handles high level control.

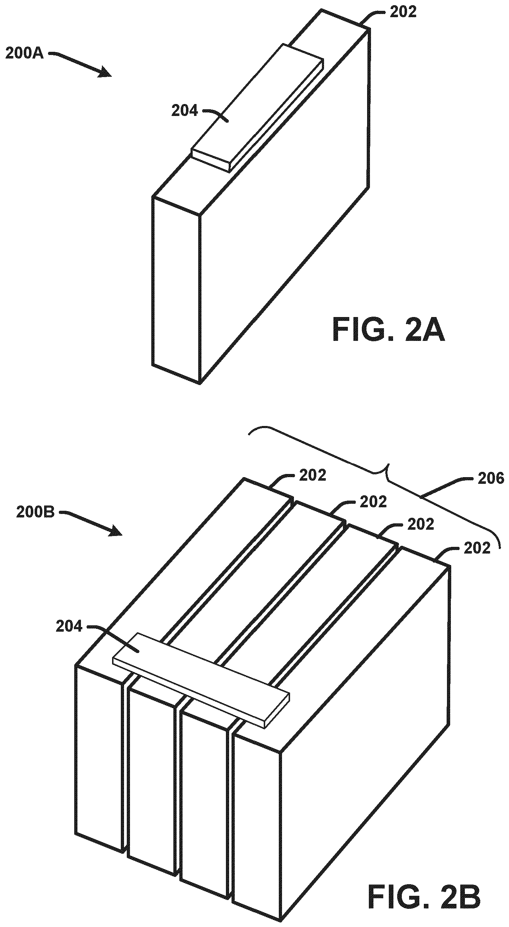

FIG. 2A and 2B illustrate example battery cell units of the smartcell battery system 102 in accordance with one or more embodiments described herein. FIG. 2A illustrates an example battery cell unit 200A comprising a single battery cell 202. FIG. 2B illustrates another example battery cell unit 200B comprising a plurality of battery cells 202. With reference to FIGs. 1, 2A and 2B, in various embodiments, all or some of the battery cell units 106 A1-A*n*, B1-B*n*, and C1-C*n* shown in FIG. 1 can correspond to battery cell unit 200A and/or battery cell unit 200B. As shown in FIG. 2A in some embodiments, one or more of the battery cell units 106 can comprise a single battery cell 202. In other embodiments, one or more of the battery cell units 106 can comprise a cluster 206 of battery cells 202, wherein the cluster 206 can comprise two or more battery cells 202. The number of battery cells 202 included in a cluster 206 can vary. For example, although battery cell unit 200B is illustrated with four battery cells 202, it should be appreciated that the number of battery cells 202 can be tailored for different usage scenarios and power demands. The battery cells 202 can respectively comprise any type of battery cell material such as, for instance, a lithium battery cell material, a lithium ion (Li-Ion) battery cell material, a lithium metal battery cell material, a lithium sulphur (Li-S) battery cell material, a molten salt (Na-NiCl2) battery cell material, a nickel metal hydride (Ni-MH) battery cell material, a lead acid battery cell.

All or some of the battery cell units 106 A1-A*n*, B1-B*n*, and C1-C*n* can include a PCB device 204 formed thereon and electrically connected to one or more the battery cells 202 respectively associated with the battery cell units 106. For example, the PCB device 204 can be physically attached to a single battery cell 202 or one or more of the respective battery cells 202 included a cluster 206. The manner in which the PCB device 204 is physically attached to a single battery cell 202 (e.g., as exemplified with respect to battery cell unit 200A) and/or a cluster 206 of battery cells (e.g., as exemplified with respect to battery cell unit 200B) can vary. For example, the PBC device 204 may be materially bonded to one or more battery cells 202, such as via one or more welded bonds (e.g., solder material welded bonds, laser material welded bonds, etc.) and/or via one or more adhesive material bonds). Alternatively, the PCB device 204 may be attached to one or more battery cells 202 via one or more screw connections.

The manner in which the PCB device 204 (or components thereof) is electrically connected to a single battery cell 202 and/or cluster 206 of battery cells 202 can also vary. For example, each of the battery cells 202 can comprise one or more terminals or power points (not shown) and the PCB device 204 (or components thereof) can be electrically connected to at least one terminal of the battery cells 202 via any suitable thermal connections (e.g., busbars, direct metal-to-metal component connections, wired connections, etc.). In some embodiments, each of the battery cells 202 can comprise four terminals or output points, wherein two of these may be AC terminals or power points and two may be isolated DC terminals or power points. In some embodiments as applied to a cluster 206 of battery cells 202, the PCB device 204 (or components thereof) may be electrically connected to at least one terminal of each battery cell of the cluster 206. In other embodiments as applied to a cluster 206 of battery cells 202, the PCB device 204 (or components thereof) may be electrically connected to at least one terminal of at least one battery cell 202 of the cluster 206.

The battery cell units 106 A1-A*n*, B1-B*n*, and C1-C*n* (and/or components thereof) can be electrically connected to one another (e.g., via hardwire connections) in series and/or in parallel in a suitable number to reach a desired voltage and/or to form independent subgroups of the battery cell units 106 connected to different electrical systems (e.g., one or more of the LV electrical systems 108 and/or the HV electrical systems 110) of the electric vehicle 200. The battery cell units 106 (and/or components thereof), and or subgroups of the battery cell units 106, can further be connected electrically (e.g., via hardwire connections) to one or more motors 112, one or more of the LV electrical systems 108 and/or the HV electrical systems 110.

For example, in various embodiments, some or all of the battery cell units 106, A1-n, B1-n, and C1-n (or portions thereof as applied two electric motors in a 4-wheel drive machine) can be used to feed a DC electrical current to one or more LV electrical systems 108 and/or one or more HV electrical systems 110 as well as to feed AC electrical current to the one or more motors 112. To facilitate this end, the respective PCB devices (e.g., corresponding to PCB device 204 and the like) can include a DCDC converter that can be used to generate a desired DC output voltage for feeding the LV and/or HV electrical systems. The DCDC converters of the respective battery cell units 106 can be connected in series and/or in parallel (e.g., via wired connections). The respective PCB devices can also include H-bridge and each of the H-bridges can be connected in series (via wired connections). The battery cell units 106 can feed the respective AC phase currents from (each of the three phase strings A, B and C) to the one or more motors 112 via their respective battery cell clusters and H-bridge connections independent from their respective DCDC converters which feed the DC current to the corresponding LV electrical systems 110 or HV electrical systems 112 to which they are connected. Various configurations are envisioned.

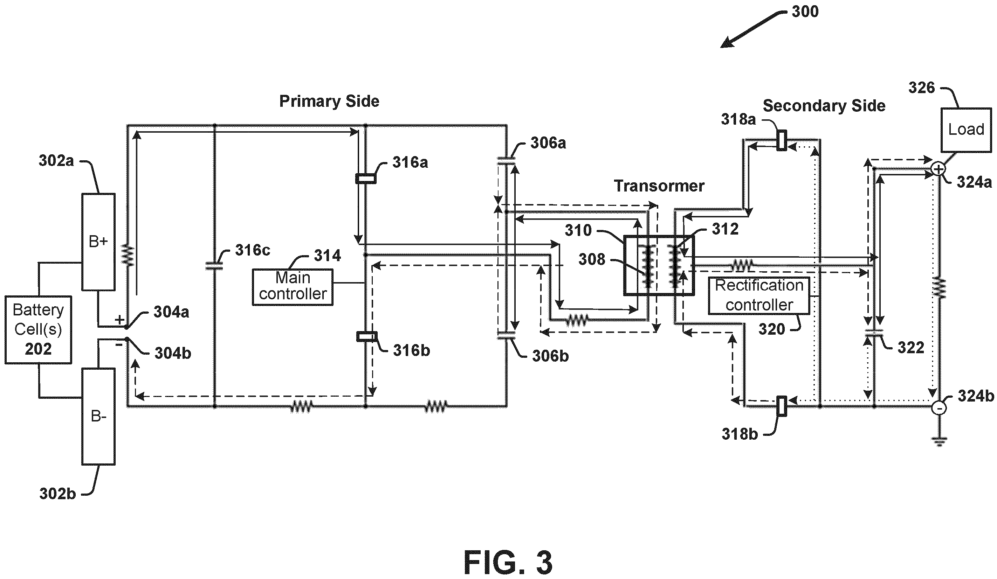

In this regard, PCB device 204 can include or correspond to a circuit board device that comprises electronic or electrical hardware (and software) components that enable the PCB device 204 to intelligently control various operations of the respective battery cells 202 connected thereto, including supplying DC output and AC output to the corresponding electrical systems of the electric vehicle 100. The electronic or electrical hardware components can include, but are not limited to: a DCDC converter, a power module comprising a number of power switches used for the DCDC converter and the H-bridge (among other functions), busbars, wires, ports, sensors, control units (e.g., comprising a microprocessor, a central processing unit (CPU) coupled to memory device, or the like), a wireless communication component (e.g., a radio frequency (RF) transmitter/receiver, transceiver, or the like), and various others. The electronic/electrical hardware components of the PCB device 204 are discussed in greater detail infra with reference to FIGs. 3-13B.

FIG. 3 illustrates a simplified circuit diagram of an example DCDC converter 300 in accordance with one or more embodiments described herein. With reference to FIGs. 1-3, in various embodiments, PCB device 204 can DCDC converter 300 and/or a similar DCDC converter. As shown in FIG. 3, the electrical components of the DCDC converter 300 can be grouped into primary side components, secondary side components and transformer components.

The transformer of the DCDC converter 300 couples the primary side and secondary side electrical components and includes a primary side winding 308, a secondary side winding 312 and a transformer core 310. The primary winding 308 and the secondary winding 312 are magnetically coupled to one another and electrically/physically isolated from one another by a small isolation distance between. In order to improve the magnetic connection between them, the transformer core 310 (e.g., formed out of graphite or another suitable material) can be formed around both the primary winding 308 and the secondary winding 312 which serves as a guide of the magnetic field which circulates around the transformer core 310 to improve magnetic coupling between the primary winding 308 and the secondary winding 310.

The primary side components can include a primary side input connection 304a (also referred to as the positive connection) and a primary side output connection 304b (also referred to as the negative connection. The input connection 304a and output connection 304b can be electrically connected to the one or more battery cells 202 via a DC input busbar 302a and a DC output busbar 302b, respectively. For example, the DC input busbar 302a can be connected to respective positive terminals of the battery cells 202 and the input connection 304a, and the output busbar 302b can be connected to respective negative terminals of the battery cells 202 and the output connection 304b. The primary side of the DCDC converter 300 further includes at least two power switches, depicted as first switch 306a and second switch 306b. These power switches can respectively include or correspond to MOSFETs or similar types of switches. The DCDC converter 300 also includes a main controller 314 that controls operations of the DCDC converter 300, including controlling switching on and off (or open and closed) of the first switch 306a and the second switch 306b. The primary side of the DCDC converter 300 further includes a plurality of capacitors, represented as capacitor 316a, capacitor 316b and capacitor 316c. Each of these capacitors 316a, 316b and 316c can respectively include or correspond to groups of capacitors, however one capacitor symbol is illustrated for simplicity here.

The secondary side electrical components can include a secondary side positive output connection 324a, a secondary side negative output connection 324b, and an output capacitor bank 322 (again represented by a single capacitor for simplicity, but can include or correspond to a group of capacitors). The positive output connection 324a can be electrically connected to a load 326, such as one or more LV electrical systems 108 and/or one or more HV electrical system 110 of the electric vehicle 100. The negative output connection 324b can be electrically connected to the ground and/or another power source in some implementations. The secondary side electrical components further include secondary side switches, represented as third switch 318a and fourth switch 318b, and a rectification controller 320 that can control switching the secondary side switches on and off (or open and closed). In some embodiments in which the DCDC converter 300 is configured to generate low output voltages (e.g., less than 50V, and typically around 15V as used to supply current to one or more LV electrical systems 108), the secondary side switches (e.g., third switch 318a and fourth switch 318b) can include MOSFETs or a similar type of power switch. In other embodiments in which the DCDC converter is configured to generate high output voltages (e.g., greater than 50V, and even up to 400V or greater as used to supply current to one or more HV electrical systems 110), the secondary side switches (e.g., third switch 318a and fourth switch 318b) can include diodes or similar switches. In some implementations of these embodiments in which the secondary side switches include diodes, the rectification controller 320 can be removed.

The primary side switches (e.g., first switch 306a and second switch 306b) and the secondary side switches (e.g., third switch 318a and fourth switch 318b) control (e.g., as controlled via the main controller 308 and the rectification controller 318 respectively) the flow of electrical current through the DCDC converter 300 between the battery cells 202 and the load 326. In particular, these switches open and close in accordance with a carefully tuned switching frequency to control the flow of current through the transformer of the DCDC converter in both forward (i.e., positive) and reverse (i.e., negative) directions on the primary side and the secondary side such that the transformer operates at a desired resonance frequency and generates a desired output voltage with low switching losses. For example, in accordance with an example operation of the DCDC converter 300, on the primary side, the current flows in a first direction (or forward/positive direction) when the first switch 306a is open and the second switch 306b is closed, as indicated by the solid arrow lines. On the primary side, the current flows in a second direction (or reverse/ negative direction) through the transformer when the first switch 306a is closed and the second switch 306b is open, as indicated by the dashed arrow lines. In this regard, the first switch 306a and the second switch 306b alternate between being open and closed which results in the current on the primary side alternating between flowing through the transformer in the forward and reverse directions. Similarly, on the secondary side, the current flows in a first direction (or forward/positive direction) when the third switch 318a is open and the fourth switch 318b is closed, as indicated by the solid arrow lines. On the secondary side, the current flows in a second direction (or reverse/ negative direction) through the transformer when the third switch 318a is closed and the fourth switch 318b is open, as indicated by the dashed arrow lines. In this regard, the third switch 318a and the fourth switch 318b also alternate between being open and closed which results in the current on the secondary side alternating between flowing through the transformer in the forward and reverse directions.

With reference to the primary side, following the current flow in the first or forward direction along the solid arrow lines, with the first switch 302a open and the second switch 302b closed, the current flows from the battery cells 202 into the DCDC converter 300 via the input DC busbar 302a, through the first switch 306a and into the primary winding 308. The current then flows through the primary winding 308 which is magnetically coupled to secondary winding 312. The electrical current then circulates between the primary winding and 308, the secondary winding current, and the transformer core 310 to generate a higher (or lower) output voltage relative to the input voltage to the primary winding 308.

In addition, on the primary side, the current then flows out of the primary winding 312 and into capacitors 316a and 316b where the current is temporarily stored. For example, the capacitors 316a and 316b can include or correspond to a resonance bank of the DCDC converter. The first switch 306a can remain open to control the flow of current into the capacitors 316a and 316b, preferably until the voltage amount retained in the capacitors is at its maximum level (e.g., corresponding to the maximum voltage capacity of the battery cells 202). In this regard, the first or forward direction flow of the current corresponds to an input flow from the battery cells into DCDC converter 300 that results in charging up the capacitors 316a and 316b.

Once the capacitors 316a and 316b have reached a desired (e.g., maximum) charge level, the first switch 306a is closed and the second switch 306b is opened. This cuts off the flow of current from the battery cells 202 and causes the voltage stored in the capacitors 316a and 316b to rush out of the capacitors and flow in the second or reverse direction indicated by the dashed arrow lines. Following the reserve flow on the primary side, the current accumulated in the capacitors 316a and 316b exists the capacitors and flows back into the primary winding 308 in the reverse direction. The current exits the primary winding 308 in the opposite direction and flows back into the primary side and to the ground and/or to the negative terminals of the battery cells 202 via the output connection 304b and the output DC busbar 302b.

With reference to the secondary side, in accordance with both the forward (solid arrow lines) and reverse flows (dashed arrow lines), the current generated by the transformer flows out of the transformer and to the load 326 connected to the positive output connection 324a. Residual current (e.g., indicated by the dotted arrow lines) can also flow between the positive output connection 324a and the negative output connection 324b (which can be connected to the ground or another element) and around the secondary side circuit. In both the forward and reverse flows, in association with the flow of current between the transformer and the load, the current (or a portion thereof) can be temporarily stored and/or filtered via the output capacitor bank 322. For example, the output capacitor bank 322 can function as a rectification filter of the DCDC converter 300 through which the secondary side forward and reverse currents are filtered prior to being transferred to the load 326 via the positive output connection 324a. As noted above, on the secondary side, the third switch 318a and the fourth switch 318b alternate between being open and closed which results in the current on the secondary side alternating between flowing through the transformer in the forward (solid arrow lines) and reverse directions (dashed arrow lines).

In accordance with both the forward and reverse flows, the resonance frequency of the DCDC converter 300 is based on the alternating switching timing and frequency of the primary side switches (e.g., first switch 306a and second switch 306b) and the secondary side switches (e.g., third switch 318a and fourth switch 318b) in combination with the capacitors (e.g., capacitors corresponding to the first capacitor 316a, the second capacitor 316b and the resonance bank capacitor 322). The primary side forward and reverse flows can operate at very high switching frequencies (e.g., about 100 to 200 kHz). The switching frequency of the primary side forward and reverse flows can be tailored and controlled by the respective primary side switches 316a/316b and the secondary side switches 318a/318b to achieve a desired secondary side output voltage. Generally, the higher the switching frequency, the greater the secondary side output voltage. When these switches are controlled (e.g., via the main controller 314 and the rectification controller 320, respectively) to switch on and off in perfect timing such that the first switch 306a and the second switch 306b are switched on and off in alternating manner based on when the voltage level in the capacitors 316a and 316b matches the output voltage capacity of the battery cells 202, the DCDC converter 300 operates at it natural resonance frequency, which means optimal efficiency and lowest possible switching losses.

In one or more embodiments, the DCDC converter 300 includes or corresponds to an LLC resonant converter, which provides higher switching frequencies and reduced switching losses as compared to other types of converters (e.g., flyback converters and/or forward converters). An LLC converter uses at least two inductors (LL) and a capacitor (c) (or group of capacitors), known as an LLC configuration. An LLC converter can supply an output voltage either higher or lower than the input voltage and provide electrical isolation via a transformer. Although more complex than a flyback or forward converter, the LLC converter design can yield higher output power and use parts that are smaller and less expensive (among other benefits).

A conventional LLC converter can be described as comprising four primary elements, including the main power switches (e.g., MOSFETs or the like), the resonant tank, the transformer, and the recitation elements. The main power switches can be implemented in full-bridge or half-bridge topologies. The main power switches (e.g., corresponding to the first switch 306a and the second switch 306b) convert the input DC voltage into a high-frequency square wave. This square wave then enters the resonant tank, which eliminates the square wave's harmonics and outputs a sine wave of the fundamental frequency. The resonant tank is made up of a resonant capacitor and two inductors: the resonant inductor, in series with the capacitor and transformer, and the magnetizing inductor, in parallel. The tank's role is to filter out the square wave's harmonics, outputting a sine wave of the fundamental switching frequency to the input of the transformer. The sine wave is transferred to the secondary of the converter through a high-frequency transformer, which scales the voltage up or down, according to the application. Lastly, the rectifier converts the sine wave into a stable DC output. The rectification circuit can be implemented as a full-wave bridge or a tapped configuration with a captative output filter.

In accordance one or more embodiments, the DCDC converter 300 as integrated on and/or within PCB device 204, (wherein PCB device 204 corresponds to PCB device 400 as described with reference to FIGs. 4-13B), achieves an LLC type converter design and functionality with fewer components (thus making it less costly) and with a planar geometry, thus minimizing the overall thickness of the PCB device 204. To facilitate this end, the DCDC converter 300 uses a unique physical design and configuration of the various electrical components described above with reference to FIG. 3. This unique design and configuration of the DCDC converter as well as other unique features and functionalities of the PCB device 204 are described in greater detail with reference to FIGs. 4-13B.

FIG. 4 illustrates a top surface view of an example PCB device 400 in an assembled configuration, in accordance with one or more embodiments described herein. With reference to FIGs. 1-4, in various embodiments, PCB device 400 can include or correspond to PCB device 204 (or vice versa). In this regard, PCB device 400 (or components thereof) can be configured to be physically and electrically connected to one or more battery cells 202 of one or more of the battery cell units 106 A1-A*n*, B1-B*n*, and C1-C*n* and control various operations of the respective battery cells 202 connected thereto, including drawing power from the respective battery cells 202 in association with supplying power therefrom to the one or more motors 112, the one or more HV electrical systems 110 and/or the one or more LV electrical systems 108, and transferring energy to the respective battery cells 202 in association with charging operations.

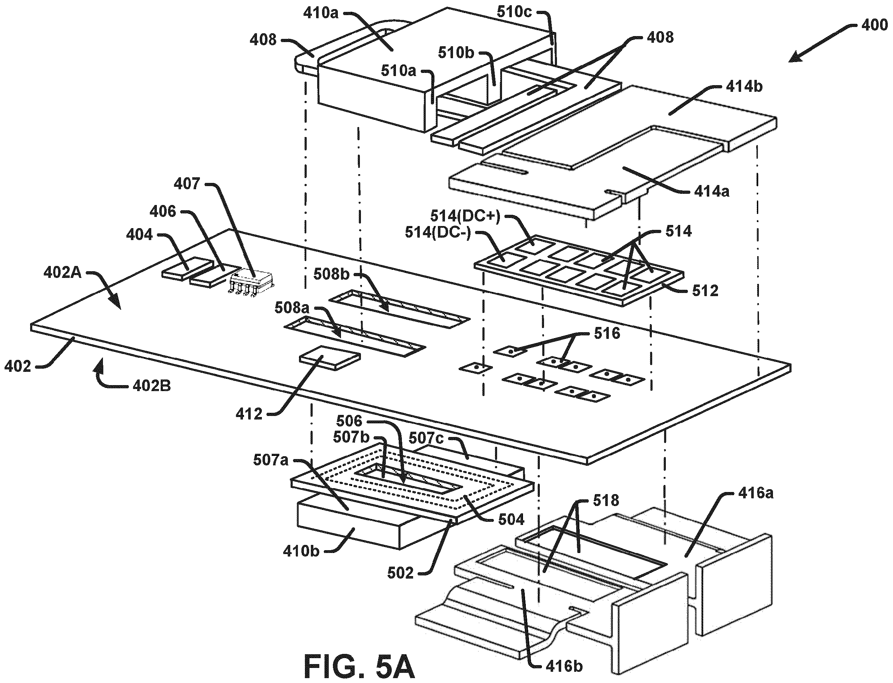

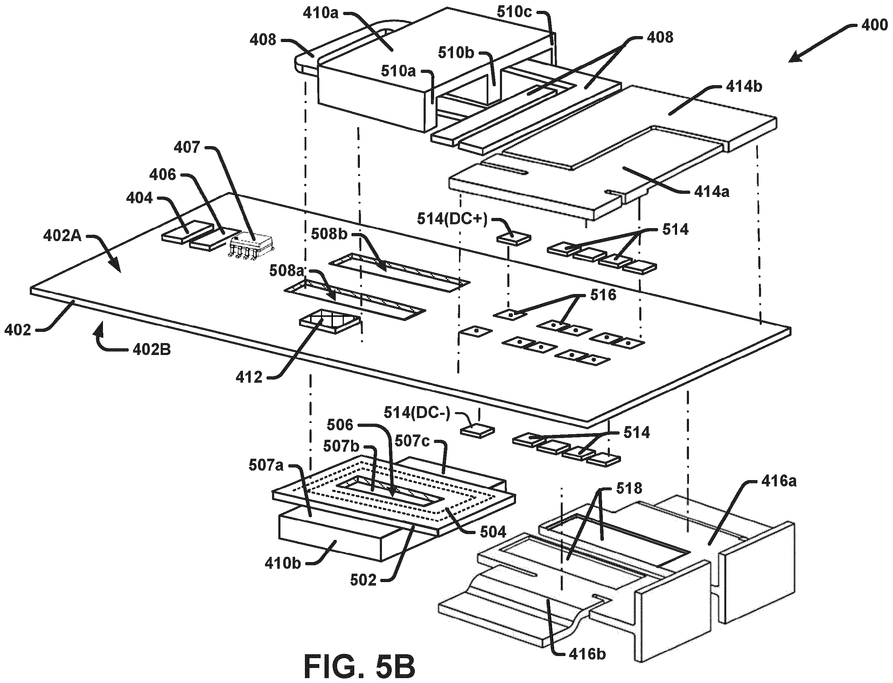

FIG. 5A illustrates an exploded, disassembled view of PCB device 400 in accordance with one or more first embodiments. FIG. 5B illustrates another exploded, disassembled view of PCB device 400 in accordance with one or more second embodiments described herein. As illustrated in FIGs, 5A and 5B, the respective components of the PCB device 400 are positioned relative to one another in the manner in which they are configured to be assembled to form the assembled configuration of the PCB device 400 illustrated in FIG. 4.

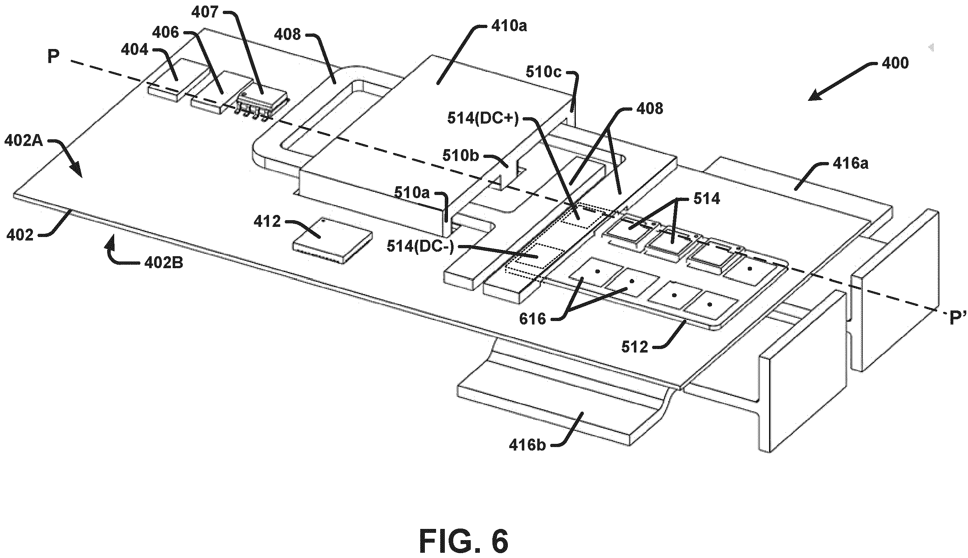

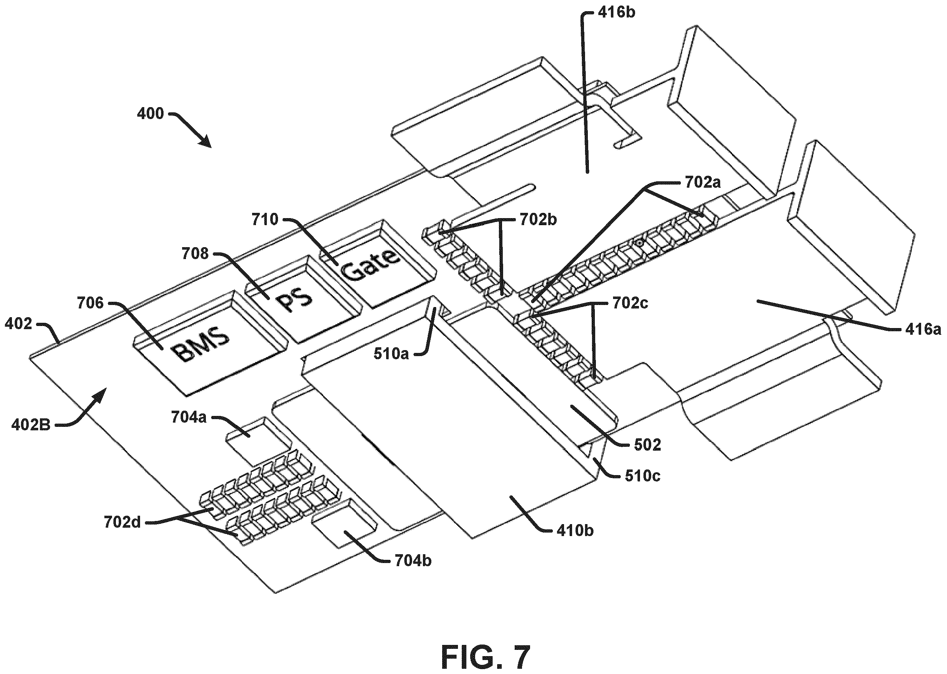

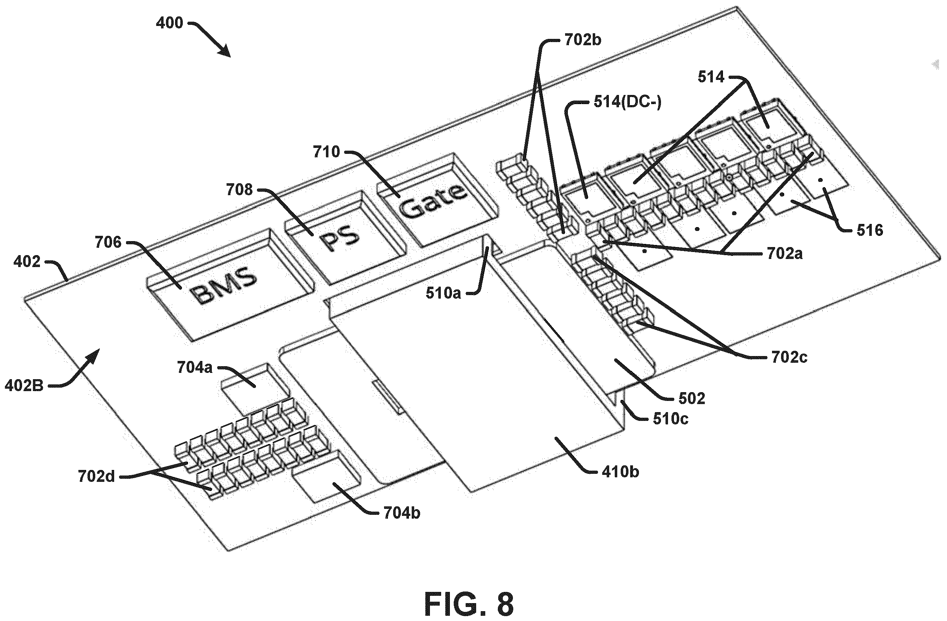

FIG. 6 illustrates another top surface view of PCB device 400 with the top surface busbars removed (e.g., first upper busbar 414a and second upper busbar 414b), in accordance with one or more embodiments described herein. FIG. 7 illustrates a bottom surface view of PCB device 400 in accordance with one or more embodiments described herein. FIG. 8 illustrates another bottom surface view of PCB device 400 with the bottom surface busbars removed (e.g., first lower busbar 416a and second lower busbar 416b), in accordance with one or more embodiments described herein.

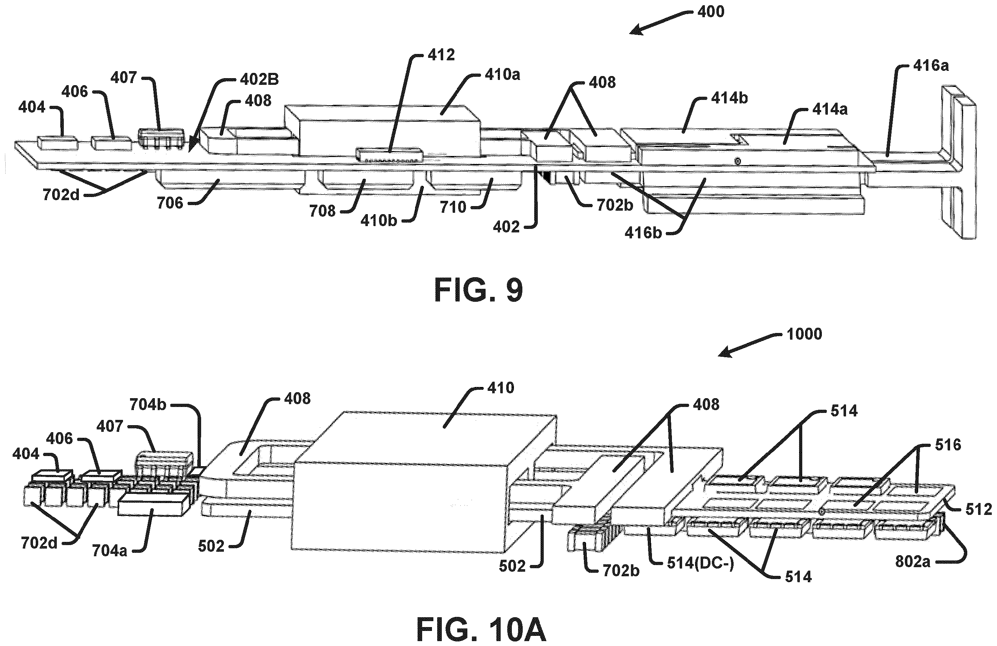

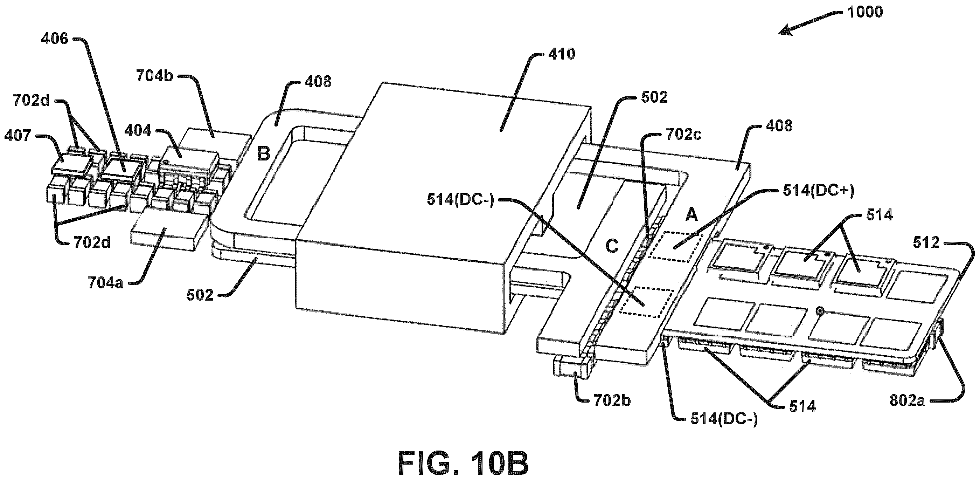

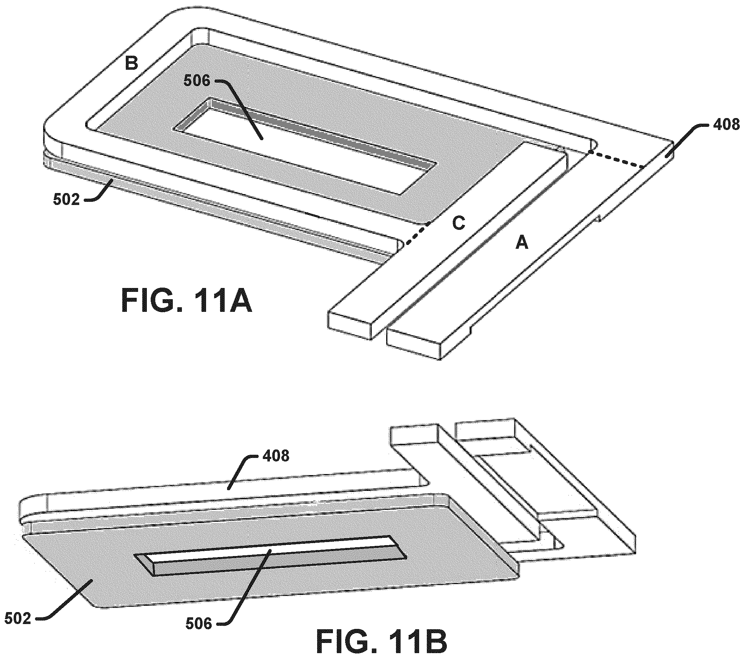

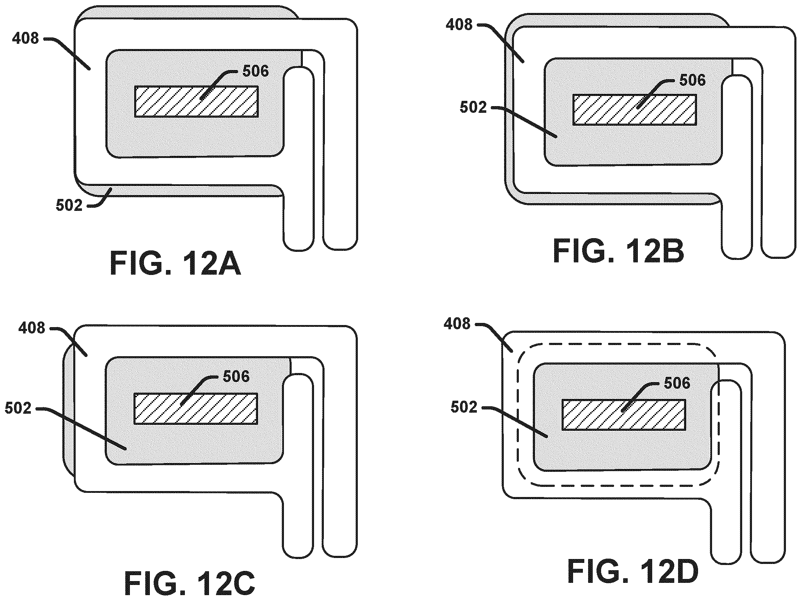

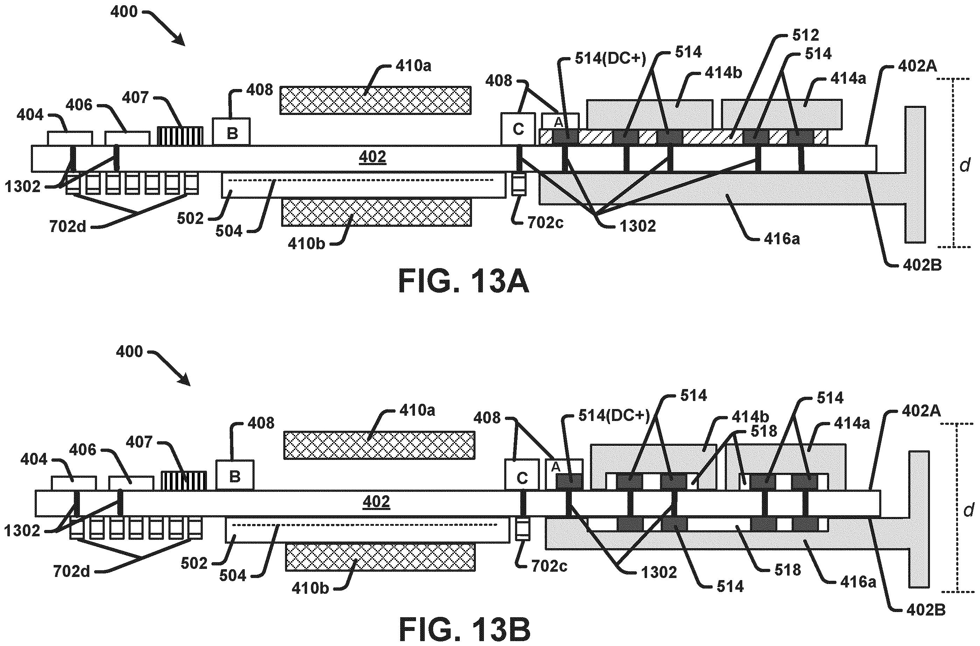

FIG. 9 illustrates a (left) side view of an PCB device 400 in accordance with one or more embodiments described herein. FIGs. 10A and 10B illustrate side (left) views of PCB device 400 with the primary substrate (e.g., primary substrate 402) removed, in accordance with one or more embodiments described herein. FIGs. 11A and 11B illustrate isolated views of the primary winding (e.g., primary winding 408) and the secondary winding (e.g., substrate 502 comprising secondary winding 504), in accordance with one or more embodiments described herein. FIGs. 12A-12D illustrate different configuration of the primary and secondary windings in accordance with one or more embodiments described herein. FIGs. 13A and 13B illustrate cross-sectional views of example PCB device 400 in accordance with one or more embodiments described herein. The cross-sectional views illustrated in FIGs. 13A and 13B respectively depict cross-sections of PCB device 400 as sliced along the P-P' axis line as placed relative to the PCB device 400 as illustrated in FIG. 6 yet with the upper busbars 414a and 414b included. It is noted that in FIGs. 11A-13B only, some of the same electrical components of the PCB device 400 presented in FIGs. 4-10A are illustrated with a patterned or shaded fill for ease of illustration.

With reference to FIGs. 4-13B, in view of FIGs. 1-3, PCB device 400 includes a plurality of electrical components formed on opposite sides of a primary substrate 402. As illustrated in FIG. 4, the primary substrate 402 can have a planar or substantially planar and rectangular geometry defined by a planar layer of material with maximum linear dimensions along the X-Z plane. For example, as illustrated in FIG.4, the primary substrate 402 can be defined by a length that extends laterally relative to axis X-X', a width that extends laterally along axis Z-Z' and a minimal thickness or height that extends longitudinally or vertically in the Y-Y' direction (e.g., less than 1.0 mm, preferably less than 0.5 mm, and even more preferably less than 0.2 mm). In this regard, the primary substrate 402 has a planar or substantially planar and rectangular body defined by parallel and opposing surfaces, referred to herein as the top surface 402A (e.g., also referred to as the first surface) and the bottom surface 402B opposite the first surface (e.g., also referred to as the second surface). The primary substrate 402 can further be defined left side, a right side opposite the left side, a distal end and a proximal end.

Hereinafter, the relative positions, orientations and dimensions of the electrical components of the PCB device 400 (and the PCB device as a whole unit) are described relative to the three-dimensional (3D) position and orientation of the primary substrate 402 defined by the top surface 402A, the bottom surface 402B, the left side, the right side, the distal end and the proximal end of the primary substrate 402 relative to the X-X',Y-Y' and Z-Z' axis's as illustrated in FIG. 4. For example, reference to a top surface or topside of a component refers to the surface/side oriented towards Y of axis Y-Y', reference to the bottom surface/side refers to the surface/side oriented towards Y' of axis Y'-Y', reference to the left side/surface refers to the surface/side oriented to Z of axis Z-Z', reference to the right side/surface of a component refers to the surface/side oriented towards Z' of axis Z-Z' and on.

The primary substrate 402 may be formed with one or more layers of suitable dielectric materials and/or conductive materials. For example, in some embodiments, the primary substrate 402 can comprise one or more first conductive layers or regions (e.g., conductive metal material layers or regions) positioned on or near the top surface 402A, one or more second conducive layers or regions (e.g., conductive metal material layers or regions) positioned on or near the bottom surface 402B, and a dielectric core formed between the one or more first conductive layers and the one or more second conductive layers. The primary substrate 402 can also include a plurality of electrical connectors or vias (e.g., electrical connectors 1302 illustrated in FIGs. 13A and 13B) formed within the thickness of the primary substrate 402 that extend through the substrate to the opposite surfaces thereof that can electrically connect one or more electrical components formed on the top surface 402A to one or more electrical components formed on the bottom surface 402B. The top surface 402A and/or the bottom surface 402B of the primary substrate 402 can also include a plurality of traces (not shown) formed thereon that provide the electrical connections between the electrical components respectively formed thereon, in accordance with conventional PCB fabrication technologies.

With reference to the top surface 402A of PCB device 400 as illustrated in FIG. 4 (and in many of the other FIGs. 5A-13B) in view of FIG. 3, the electrical components formed on the top surface 402A can include (but are not limited to), a secondary side DC positive output connection 404 (e.g., corresponding to positive output connection 324a), a secondary side negative output connection 406 (corresponding to negative output connection 324b), a rectification controller 407 (corresponding to rectification controller 320), a primary winding 408 (corresponding to primary winding 308), a portion (e.g., upper portion 410a) of the transformer core 410 (e.g., corresponding to transformer core 310), a main DCDC controller 412 (e.g., corresponding to main controller 314), a first upper busbar 414a and a second upper busbar 414b. In various embodiments, the first upper busbar 414a and the second upper busbar 414b respectively correspond to busbars that distribute electrical current between electrical components of the PCB devices 400 that are disassociated with the DCDC converter of the PCB device (e.g., except for the snubber in some implementations, as described infra). For example the first upper busbar 414a and the second upper busbar 414b can include or correspond to input and/or output busbars configured to distribute high voltage AC energy between the power module of the PCB device 400 (e.g., which is formed underneath the first upper busbar 414a and the second upper busbar 414b, as described infra) and one or more external electrical systems to which the respective busbars are connected (e.g., one or more motors 112 of the electric vehicle). The first upper busbar 414a and the second upper busbar 414b respectively include or correspond to relatively large, planar metal plates formed with one or more conducting metals (e.g., copper, aluminum, gold, etc.).

With reference to FIGs. 5A, 5B and 6, in some embodiments, the top surface 402A of the primary substrate 402 can also include a power module comprising a plurality of power switches 514 (e.g., MOSFETs, FETs or similar types of semiconductor switches) formed on the top surface 402A of the primary substrate 402 directly below first upper busbar 414a and the second upper busbar 414b. For example, in some embodiments, as illustrated in FIGs. 5A and 6, the power module can comprise a plurality of power switches 514 formed on and/or within a substrate 512 having a planar geometry. The number and type of power switches 514 formed on or within the substrate 512 can be tailored for different applications of the PCB device 400. For example, as illustrated in FIG. 5A, the substrate 512 includes eight power switches 514, and as illustrated in FIG. 6, some of these power switches are removed from the second substrate 512 to reveal switch connection regions 616. In this regard, in some embodiments, the substrate 512 can include switch connection regions 616 corresponding to preconfigured connection regions for attaching (e.g., via soldering or another suitable attachment mechanism) one or more power switches 514 thereto. With these embodiments, the number and type and position of the power switches 514 formed on or within the substrate 512 can be selectively adapted for different applications of the PCB device 400.

For example, in some embodiments, each of the power switches 514 may be include or correspond to prepackaged individual switches that are can be independently soldered to and/or embedded within the substrate 512 at the connection regions 616. In some implementations of these embodiments, the connection regions 616 can include electrical connectors (e.g., vias or the like, indicated by the black dots positioned within the connection regions 616) that extend through the thickness of the substrate 512 that electrically connect the power switches 514 formed thereon to other electrical components positioned on the opposite surfaces of the substrate 512.

In other embodiments, the power switches 514 can be embedded within the thickness of the substrate 512, as illustrated in FIG. 13A. With these embodiments, respective source and drain regions of the power switches 514 can be exposed on opposite sides of the second substrate 512. With these embodiments, the connection regions 616 illustrated in FIG. 6 can include or correspond to openings that extend through the thickness of the substrate 512 in which the power switches 514 can be inserted. Still in other embodiments, the substrate 512 comprising embedded power switches 514 formed within the thickness thereof can include or correspond to a prepackaged power module that is manufactured and obtained as a single unit. With these embodiments, the number, type and arrangement of the power switches 514 as integrated within the substrate 512 can be tailored for applications of the PCB device 400 at the time of manufacture thereof.

As illustrated in FIGs. 5A and 5B, the top surface 402A of the primary substrate 402 can also include connection regions 516 formed thereon at positions corresponding to the locations where the power switches 514 are attached thereto. For example, the connection regions 516 can include electrical connectors (e.g., electrical connectors 1302 as illustrated in FIGs. 13A and 13B) such as vias or the like which extend through the thickness of the primary substrate 402 from the top surface 402A to the bottom surface 402B. These electrical connectors can electrically connect the power switches 514 positioned thereon to other electrical components formed on the opposite surface of the primary substrate 402.

Additionally, or alternatively, the power module defined by substrate 512 comprising and power switches 514 embedded therein can be assembled on the bottom surface 402B of the primary substrate 402 at a mirrored position to that illustrated in FIGs. 5A, 6 and 13A. With these embodiments, the connection regions 516 illustrated in FIG. 5A can additionally or alternatively be formed on the bottom surface of the primary substrate at mirrored positions corresponding to those illustrated in FIG. 5A.

Still in other embodiments, as illustrated in FIG. 5B and 13B the power switches 514 can be include or correspond to individual switches that are individually and separately attached directed to the top surface and/or the bottom surface of the primary substrate 402 at positions corresponding to the connection regions 516. With these embodiments, the power switches 514 can be directly assembled (e.g., soldered or using another suitable attachment mechanism) on the top surface 402A and/or the bottom surface 402B of the primary substrate 402 at the positions of the connection regions 516. Electrical connectors (e.g., electrical connectors 1302) formed within the thickness of the primary substrate 402 (e.g., extending from the top surface 402A to the bottom surface 402B) at positions corresponding to the connection regions 516 can further electrically connect the power switches 514 formed on the top surface 402A to electrical components formed on the bottom surface 402B (or vice versa). With these embodiments, different types of the power switches 514 can selectively be attached to the primary substrate 402 as needed and in accordance with a desired configuration relative to the connection regions 516.

As shown in FIGs. 5A and 5B, 7 (and other figures), the bottom surface 402B of the primary substrate 402 can include a lower portion 410b of the transformer core 410 (corresponding to transformer core 310), a secondary winding 504 formed on or within (e.g., as traces) a planar substrate 502 (corresponding to secondary winding 312), a first lower busbar 416a (corresponding to DC input busbar 302a) and a second lower busbar 416b (corresponding to DC output busbar 302b). In this regard, in accordance with the disclosed techniques, the secondary winding 504 of the DCDC transformer can be formed as traces (e.g., electrical patterned windings) formed on and/or within a separate substrate 502 having a planar geometry. (It is noted that the secondary winding 504, that is the patterned traces represented by the dashed lines illustrated on substrate 502 is FIGs. 5A and 5B is not shown on substrate 502 in other figures for ease of illustration. In this regard, although not shown, it should be appreciated that every illustrated instance of substrate 502 in FIGs. 5A-13B includes the secondary winding 504). To this end, the transformer components of the DCDC converter of PCB device 400, corresponding to DCDC converter 300, are assembled on the primary substrate 402 with the primary winding 408 positioned on the top surface 402A, the substrate 502 including the secondary winding 504 positioned below the primary winding 408 on the bottom surface 402B, and the transformer core 410 being formed around the primary winding 408 and the secondary winding 504 on both the top surface and the bottom surface of the primary substrate. For example, as illustrated in FIGs. 9 and 10A, as assembled, the upper portion 410a and the lower portion 410b are combined and connected to form the transformer core 410 around the primary winding 408 and the substrate 502 comprising the secondary winding 504.

In particular, as shown in FIGs. 5A and 5B, the transformer core 410 can be formed out of an upper portion 410a configured to be assembled on the top surface 402A of the primary substrate 402 and a lower portion 410b configured to be assembled on the bottom surface 410B of the primary substate 402 at a position directly below the upper portion 410a. As assembled on the primary substrate 402, the upper portion 410a is physically attached (e.g., via soldering or another suitable attachment mechanism) to the lower portion 410b via openings 508a and 508b formed through the primary substrate 402 and an opening 506 formed through substrate 502 comprising the secondary winding 504. For example, the upper portion 410a can have a geometrical shape corresponding to an upside uppercase letter "E", with a planar top surface and three longitudinal walls (e.g., first wall 510a, second wall 510b and third wall 510c) that extend vertically towards the primary substrate 402 (e.g., in the longitudinal direction along axis Y-Y' illustrated in FIG. 4) in a direction perpendicular to the planar top surface. The primary winding 408, also having a planar geometry, is further weaved through and between the three longitudinal walls (e.g., first wall 510a, second wall 510b and third wall 510c) of the upper portion 410a as positioned on the top surface 402A of the primary substrate 402.

The second substrate 502 comprising the secondary winding 504 is assembled on the bottom surface 402B of the primary substrate 402 as sandwiched between the bottom surface 402B and the lower portion 410b. As positioned relative to the bottom portion 410b, the substrate 502 can have a width (e.g., in the Z-Z' direction) that is smaller than the width (e.g., in the Z-Z' direction) of the lower portion 410b such that as positioned on the lower portion 410b, surfaces 507a and 507c of the lower portion 410b on opposite left and right sides the substrate 502 are exposed, along with a central surface 507b of the lower portion 410b exposed within the opening 506 of the substrate 502. The substrate 502 (and the secondary winding 504) can also have a length (e.g., in the X-X' direction) that is longer than the length of the second portion 410b such that the substrate 502 extends laterally beyond the distal and proximal ends of the lower portion 410b.

As substrate 502 and the lower portion 410b are assembled on the bottom surface 402B, the opening 506, and the central surface 507b exposed therein, is aligned with opening 508b. At the same time, surface 507a is aligned with opening 508a. The substrate 502 and the lower portion 410b can further be sized such that as assembled on the bottom surface 402A of the primary substrate 402, surface 507c of the lower portion 410b at least partially extends laterally beyond the right side edge of the primary substrate 402 in the Z-Z' direction. As the upper core portion 410a is assembled on the top surface 402A of the primary substrate 402, the second wall 510b is configured to insert through opening 508b and attach (e.g., via soldering or another suitable attachment mechanism) to the central surface 507b of the lower portion 410b as aligned with the opening 508b. At the same time, the first wall 510a is configured to insert through opening 508a and attach to surface 507a as aligned with the opening 508a. Further, the third wall 510a is configured to attach to surface 507c around the right side edge of the primary substrate 402, as illustrated in FIG. 6 (and other figures).

As shown in FIGs. 7 and 8 (and other figures), as the transformer portions of the DCDC converter of the PCB device 400 are assembled, the bottom surface 402B of the primary substrate 402 includes substrate 502 (comprising the secondary winding 504) positioned directly on the bottom surface of the primary substrate 402 with the lower core portion 410b formed around a portion of the substrate 502. In this regard, the substrate 502, which comprises the secondary winding 504, is assembled between the bottom surface 402A of the primary substrate 402 and the lower portion 410b.

As noted above, the bottom surface 402A of the primary substrate 402 includes the first lower busbar 416a (corresponding to DC input busbar 302a) and the second lower busbar 416b formed thereon. Similar to the upper busbars formed on the top surface 410A, the first lower busbar 416a and second lower busbar 416b can respectively include or correspond to relatively large, planar metal plates formed with one or more conducting metals (e.g., copper, aluminum, gold, etc.). In various embodiments, the first lower busbar 416a corresponds to the DC input busbar 302a and the second lower busbar 416b corresponds to the DC output busbar 302b. In this regard, the first lower busbar 416a can be connected to respective positive terminals of the battery cells 202 and configured to distribute an input electrical current from the battery cells 202 to the DCDC converter of the PCB device 400. Likewise, the second lower busbar 416b can be connected to respective negative terminals of the battery cells 202 (and the "ground" in some implementations) and configured to distribute an output electrical current from the DCDC converter to the battery cells 202.

As described above with reference to FIG. 5B, and as the bottom surface 402B is shown in FIG. 8 with the first lower busbar 416a and the second lower busbar 416b removed relative to the bottom surface 402B as shown in FIG. 7, in some embodiments, the bottom surface 402B of the primary substrate 402 can include a plurality of power switches 514 formed between the first and second lower busbars and the bottom surface 402A. As illustrated in FIG. 8, the plurality of power switches 514 include a row of switches formed on the bottom surface 402A at a position aligned with the second lower busbar 416a, and not the first lower busbar 416a, only for exemplary purposes. In this regard, in some embodiments, one or more power switches 514 may additionally or alternatively be formed directly below the first lower busbar 416a at positions corresponding to the connection regions 516. In this regard, as noted above with reference to FIGs. 5A and 5B, in some embodiments, similar to the top surface 402A, the bottom surface 402B of the primary substrate 402 can also include connection regions 516 formed thereon at positions mirroring those illustrated on the top surface as shown in FIGs. 5A and 5B.

The bottom surface 402B of the primary substrate 402 can further include a plurality of capacitors, including capacitors 702a, capacitors 702b, capacitors 702c and capacitors 702d. In various embodiments, capacitors 702b and capacitors 702c, positioned adjacent to the proximal end substrate 502 (comprising the secondary winding 504), can respectively correspond to capacitor 316a and capacitor 316b of DCDC converter 300. Similarly, capacitors 702d, positioned adjacent to the distal end of substrate 502, can correspond to capacitor 322 of DCDC converter 300. As shown in FIG. 7, the capacitors 702b and capacitors 702c can be positioned on the bottom surface 402B in row or straight line that is parallel to the distal and proximal ends of the primary substrate 402B. The row of capacitors 702b and 702c is further positioned laterally between the proximal end of substrate 502 and the distal ends of the lower busbars (e.g., first lower busbar 416a and second lower busbar 416b).

In some embodiments, capacitors 702a can correspond to capacitor 316c of DCDC converter 300. As discussed in greater detail below, capacitors 702a can correspond to an electrical component referred to as a snubber and provide dual functions for the PCB device 400, including a function serving the DCDC converter and another function unrelated to the DCDC converter. As shown in FIGs. 7, the capacitors 702a can be formed in a row on the bottom surface 402A between the first lower busbar 416a and the second lower busbar 416b in the Z-Z' direction. To this end, the row of capacitors 702a and the row of capacitors 702b and 702c collectively form a "T' shape configuration. Likewise, as shown in FIG. 8, power switches 514 and/or connection regions 516 can be formed on the bottom surface 402B on opposite left and right sides of the capacitors 702a.

The bottom surface 402B can also include a first rectification switch 704a corresponding to the third switch 318a of DCDC converter 300, and a second rectification switch 704b corresponding to the fourth switch 318b of DCDC converter 300. The bottom surface 402A can also include a battery management system 706, a power supply unit 708 and a gate controller 710 that serve functions of the PCB device 400 unrelated to the DCDC converter.

With reference particularly to the power switches 514 of PCB device 400, in various embodiments, the power switches 514 can collectively correspond to the power module of the PCB device 400. These power switches 514 may be formed on the top surface 402A and/or the back surface 402B of the primary substrate 402. These power switches 514 may be formed on and/or embedded within substate 512 which is then attached to the top surface 402A (e.g., via soldering or another suitable attachment mechanism) with the power switches 514 aligned with the connection regions 516 (as shown in FIG. 5A) and/or attached to the bottom surface 402B with the power switches 514 aligned with the connection regions 516. Additionally, or alternatively, these power switches 514 may be individually and separately attached (e.g., via soldering or another suitable attachment mechanism) to top surface 402A and/or the bottom surface 402B at positions corresponding to the connection regions 516 (as shown in FIG. 5B). The number of power switches 514 associated with the power module can vary and be tailored depending on desired power capabilities of the PCB device 400. In an example, implementations, the number of power switches associated with the power module can include about 10 to 14 power switches 514.

The power switches 514 can include MOSFETs (and/or other types of power switches) that can control very high electrical currents associated with the DCDC converter and other circuits of the PCB device 400 (e.g., an H-bridge circuit among others). In particular, at least some of the power switches 514 can control the flow of electrical current between the lower busbars (e.g., first lower busbar 416a and second lower busbar 416b) and the transformer of the DCDC converter of PCB device. Other ones of the power switches 514 can control the flow of very high electrical current between the upper busbars (e.g., first upper busbar 416a and second upper busbar 416b) and other circuits of the PCB device (e.g., an H-bridge circuit among others). To facilitate this end, the powers switches 514 require a very low resistance (e.g., <0.5 mOhm).

In accordance with the disclosed techniques, the power module of PCB device 400 (e.g., consisting of the power switches 514 and substrate 512 in some embodiments) is sandwiched between the upper and lower busbars respectively formed on opposite surfaces (e.g., top surface 402A and bottom surface 402B) of the primary substrate 402 in order to create the shortest possible current transfer distance between the power switches and the busbars. For example, as described above, the upper busbars (e.g., first upper busbar 414a and second upper busbar 414b) and the lower busbars (e.g., first lower busbar 416a and second lower busbar 416b) can include or correspond to relatively large, planar (or substantially planar) metal plates of a conducting metal (e.g., copper, aluminum, gold, etc.). As positioned on opposite surfaces of the planar primary substrate 402, the upper busbars are stacked above the lower busbars (e.g., as illustrated in FIGs. 4, 5A, 5B, 9, 13A and 13B) to form opposing, parallel layers of metal on opposite surfaces of the planar, primary substrate 402 with the power module (e.g., power switches 514) formed on the primary substrate 402 and sandwiched between the opposing, parallel metal layers. In this regard, as illustrated in FIGs. 4, 7 and 9 the substrate power switches 514 are hidden from the illustrated views of the PCB device 400 because they are covered by the upper and/or lower busbars. With this configuration, the current path between the busbars and the power switches 514 is vertical through the power switches (e.g., perpendicular to the parallel planar surfaces of the upper and lower busbars and the primary substrate 402). This helps to minimize switching inductance, minimize switching losses, maximize cooling and reduces the resistance to an absolute minimum. In addition, in accordance with some implementations of the smartcell battery system 102, the lower and/or upper busbars are already water cooled in close vicinity to the power module. Thus, by sandwiching the power switches 514 between the conducting busbars, the cooling of the busbars synergistically cools the power switches.

In addition, by sandwiching the power switches 514 between the upper and lower busbars, the power switches can be directly connected to the busbars. For example, as illustrated in FIG. 13A, in one or more embodiments in which the power switches 514 (illustrated with black fill in FIGs. 13A and 13B) are embedded within substrate 512, each of the power switches 514 can include source and drain regions (not shown) that are respectively exposed on opposite sides of the substrate 512. The power switches 514 can extend longitudinally between opposing top and bottom surfaces of the substrate 512 such that opposite sides of the switches are exposed at the opposing surfaces of the substrate 512. The exposed, opposite sides of the power switches 514can respectively include the switch source and drain regions. The primary substrate 402 can further include electrical connectors 1302 formed through the thickness of the primary substrate 402 that are exposed on the top surface 402A and the bottom surface 402B of the primary substrate (e.g., prior to assembly of the power module thereon). The electrical connectors 1302 can include or correspond to metal plated (e.g., copper or another conducive metal) holes or vias that transfer current and heat vertically (e.g., in the longitudinal direction) to the opposite surfaces of the primary substrate 402. In this regard, as assembled and shown in FIG. 13A, the power switches 514 embedded within substrate 512 and positioned on the top surface 402A off the primary substrate 402 can respectively be electrically connected to the first lower busbar 416a (and/or the second lower busbar 416b, which is excluded from the cross-sectional views shown in FIGs. 13A and 13B) positioned on the bottom surface 402B of the primary substrate 402 via the electrical connectors 1302. (As a reminder, cross-sectional views illustrated in FIGs. 13A and 13B respectively depict cross-sections of PCB device 400 as sliced along the P-P' axis line as placed relative to the PCB device 400 as illustrated in FIG. 6 yet with the upper busbars 414a and 414b included). The power switches 514 can further be directly electrically connected to the upper busbars (e.g., first upper busbar 414a and/or second upper busbar 414b) positioned directly above the power switches 514 (e.g., via direct contact between the top surfaces of the power switches 514 and the bottom surfaces of the upper busbars and/or via other suitable conductive connection mechanism). For example, the PCB device 400 can be assembled by soldering (or another suitable attachment mechanism) the substrate 512 comprising the embedded power switches 514 directly to the top surface 402A of the primary substrate 302 and thereafter soldering the upper busbars 414a and 414b directly to substrate 512. Likewise, the lower busbars 416a and 416b can be soldered directly to the bottom side 402B of the primary substrate 402.

Additionally, or alternatively, the power module defined by substrate 512 comprising the power switches 514 embedded therein can be assembled on the bottom surface 402B of the primary substrate at a mirrored position to that illustrated in FIGs. 5A, 6 and 13A.

Additionally, or alternatively, the power module of the PCB device 400 can be formed using power switches 514 that are manufactured as pre-packaged individual switches that are can be independently soldered to the top surface 402A and/or the bottom surface 402B of the primary substrate 402, as illustrated in FIGs. 5A, 8 and FIG. 13B. (In some implementations of these embodiments, the pre-packaged power switches may be provided with two or more prepackaged switches that are embedded within a substrate corresponding to substrate 512). With these embodiments, the power switches 514 can be directly assembled (e.g., via soldered or using another suitable attachment mechanism) on the top surface 402A and/or the bottom surface 402B of the primary substrate 402 at the positions of the connection regions 516 (and the electrical connectors 1302). With these embodiments, different types of the power switches 514 can be selectively attached to the primary substrate 402 as needed and in accordance with a desired configuration relative to the connection regions 516.

In some implementations of these embodiments, the power switches 514 can include exposed source and drain regions on opposite sides thereof as described above. With these embodiments, the power switches 514 may operate bi-directionally regardless of the surface of the primary substrate to which they are attached and can be directly electrical connected to the upper and/or lower busbars as described above. In other implementations of these embodiments in which the power switches 514 do not include source and drain regions on both sides thereof, the power switches 514 must be placed on the primary substrate 402 with the gate connections of the respective switches facing the surface of the primary substrate to which they are attached (e.g., either the top surface 402A or the bottom surface 402B). In other words, unidirectional power switches must be placed on opposite sides of the primary substrate 402 (e.g., a first direction on one side and the reverse direction on the other side).

In accordance with some embodiments in which the power switches 514 are separately attached to the primary substrate 402, the thickness of the power switches 514 (e.g., in the longitudinal or vertical direction), can add to the overall thickness (e.g., represented by distance "d" in FIGs. 13A and 13B) of the assembled PCB device 400, as the respective switches will extend from the respective surfaces of the primary substrate 402 to which they are attached. In some implementations of these embodiments, to counterbalance the added thickness of the power switches 514 one or more of the upper busbars (e.g., first upper busbar 414a and second upper busbar 414b) and/or the lower busbars (e.g., first lower busbar 416a and/or 416b) can include recessed regions 518 at positions corresponding the power switches 514 and the power 514 switches can be assembled within the recessed regions, as illustrated in FIG. 5B and FIG. 13B.

In various embodiments, an overall thickness "d" of the entirety of PCB device 400 of about 1.0 mm (e.g., in some implementations 1.0 mm, in others less than 1.0 mm and in others less than 1.5 mm) can be achieved using the design and configuration of the electrical components as described herein, owing to the planar geometry of the larger components and the direct connections between several components, as described herein.

With reference now particularly to the DCDC converter of PCB device 400, as noted above, in various embodiments, the DCDC converter of PCB device 400 can include or correspond to DCDC converter 300. In this regard, the electrical components that form and/or are electrically connected to the DCDC converter of PCB device 400 can include at least those noted above as being corresponding elements to the DCDC converter 300 as illustrated in the circuit diagram of FIG. 3. For example, the electrical components of PCB device that form and/or associated with the DCDC converter include (but are not limited to): the first lower busbar 416a (corresponding to DC input busbar 302a), the second lower busbar 416b (corresponding to DC output busbar 302b), at least two of the power switches 514 (e.g., corresponding to first switch 316a and second switch 316b), capacitors 702b and capacitors 702c (corresponding to capacitors 316a and 316b respectively), capacitors 702a in some embodiments, corresponding to capacitor 316c), the main DCDC controller 412 (corresponding to main controller 314), the primary winding 408 (corresponding to primary winding 308), substrate 502 comprising the secondary winding 504 (corresponding to secondary winding 312), the transformer core 410 (corresponding to transformer core 310), capacitors 702d (corresponding to capacitor 322), the first rectification switch 704a and the second rectification switch 704b (respectively corresponding to third switch 318a and fourth switch 318b), the rectification controller 407 (corresponding to rectification controller 320), the positive output connection 404 (corresponding to positive output connection 324a), and the negative output connection 406 (corresponding to negative output connection 324b).

As opposed to using a prepackaged, standard LLC resonant converter, the disclosed techniques build the DCDC converter 300 directly on the planar, primary substrate 402 of the PCB device 400 in a manner that enables the DCDC converter to generate high power output (e.g., from 15V to up to 400V or even greater, despite operating with a low input voltage) and achieve efficient performance (e.g., low switching losses, low thermal profile, etc.) with fewer components, and thus reduced cost, while at the same time remaining compact in size (e.g., owing to the planar geometry and relative arrangement of the larger electrical components of the DCDC converter such as the transformer components and the lower busbars). In this regard, the DCDC converter is particularly configured to provide the power output needed for supplying power to the LV electrical systems and HV electrical systems of the electric vehicle 100 in association with integration on respective battery cell units 106 A1-A*n*, B1-B*n*, and C1-C*n* of the smart cell battery system 102 and using the power supplied by the respective battery cells 202 associated with each battery cell unit 106 (e.g., typically around 15V but variable deepening on the number and type of the battery cells associated with each unit). In accordance with this usage scenario, each of the battery cell units can include a PCB device 400 attached thereto to provide the various advanced features and functionalities of the smartcell battery system 102 that enable significant advantages in electric vehicle operations. Accordingly, the unique design and configuration of the DCDC converter and other electrical components of the PCB device 400 described herein enable the overall size and cost of the PCB device 400 to be amenable to this usage scenario (e.g., enabling electrical vehicles to be more affordable to the consumer) while also providing the required functionality of the PCB device 400 (e.g., the DCDC converter among other described herein) in accordance with the smartcell battery system 102.

In this regard, with reference to FIGs. 3-13B, the primary side components of the DCDC converter of the PCB device 400 can include at least two (e.g., two as applied to a half-bridge LLC converter and four as applied to a full-bridge LLC converter) primary side power switches that correspond to first switch 316a and second switch 316b. In accordance with the disclosed techniques, these primary side power switches can include at least two of the power switches 514 which are sandwiched between the upper busbars 414a and 414b and the lower busbars 416a and 416b. In particular, as shown in FIGs. 5A, 5B, 6, 8 and (and other figures), at least two of the power switches 514 are labeled as power switches 514(DC+) or 514(DC-) to indicate that these power switches correspond to the primary side power switches of the DCDC converter. These primary side DC power switches can include a first switch 514(DC+), which corresponds to first switch 306a, that controls the flow of electrical current between the input DC busbar (e.g., first lower busbar 416a) and the primary winding 408 in accordance with the forward direction or positive flow described with reference to FIG. 3. The primary side DCDC power switches can further include a second switch 514(DC-), which corresponds to second switch 306b that controls the flow of electrical current between the primary winding 408 and the output DC busbar (e.g., second lower busbar 416b), in accordance with the reverse direction or negative flow described with reference to FIG. 3).

The location of these first and second primary side DC power switches (and potentially third and fourth primary side DC power switches as applied to a full-bridge converter) relative to the primary winding 408 and the DC input and output busbars (e.g., first lower busbar 416a and second lower busbar 416b, respectively) is of particular importance and uniquely configured to afford specific functional advantages.

In this regard, as shown in FIGs. 10B, 11A, 13A and 13B, in various embodiments, the primary winding 408 can be subdivided into three subsections, including subsection A, subsection B and subsection C. In accordance with the primary side forward or positive flow of the electrical current of the DCDC converter of PCB device 400 (corresponding to the forward or positive flow represented by the sold arrow lines as described with reference to FIG. 3), the current flows from the DC input busbar (e.g., first lower busbar 416a) vertically through the primary substrate 402 into subsection section A of the primary winding 408, around subsection B, and into subsection C. As noted above and described with reference to FIG. 3, a first switch 514(DC+), corresponding to first switch 306a, controls this forward flow, that is the supply of the input electrical current from the DC input busbar (e.g., first lower busbar 416a) to subsection A of the primary winding 408. In accordance with the primary side reverse or negative flow (corresponding to the reverse or flow represented by the dashed arrow lines as described with reference to FIG. 3), the current flows from the subsection C, through subsection B, and back into subsection A, where it is then transferred back down to the DC output busbar (e.g., second lower busbar 416b). To this end, the primary winding 408 can be defined as comprising two ends, a first end corresponding to subsection A, and a second end corresponding to subsection C. As noted above and described with reference to FIG. 3, a second switch 514(DC-), corresponding to second switch 306b, controls the reverse flow, that is the supply of output electrical current from subsection A of the primary winding to the DC output busbar (e.g., second lower busbar 416b).

In order to create the shortest possible travel distance of the primary side forward (or input) and reverse (or output) current flows, the disclosed techniques position the primary side DC input and output switches (e.g., 514(DC+) and 514(DC-) directly below subsection A of the primary winding. For example, notice in FIGs. 5A, 5B, 6, 8, 10A, 10B, 13A and 13B, that portion of the power switches 514 labeled as 514(DC+) and 514(DC-) include those which are located directly below subsection A of the primary winding 408.

For example, as illustrated in FIGs. 6 and 10B, in some embodiments, the first switch 514(DC+) and the second switch 514(DC-) can be included on or within the power module substrate 512 and positioned on the top surface 402A of the primary substrate 402, directly below subsection A of the primary winding 408. In FIGs. 6a and 10B, these two power switches 514(DC+) and 514(DC-) are illustrated with dashed lines to indicate that they are covered (e.g., formed below) the corresponding portion (e.g., subsection A) of the primary winding 408 formed on the top surface of the primary substrate 402. With these embodiments, the one of power switches 514(DC+) aligned with the DC input busbar (e.g., the first lower busbar 416a) corresponds to the first switch 306a that controls the flow of electrical current from the DC input busbar to the primary winding 408, and the one of power switches 514(DC-) aligned with the DC output busbar (e.g., the second lower busbar 416b) corresponds to the second switch 306b that controls the flow of electrical current from the primary winding 408 to the DC output busbar (e.g., second lower busbar 416b).

With these embodiments, the first power switch 514(DC+) can be directly electrically connected to the corresponding portion (e.g., subsection A) of the primary winding 408 (e.g., via direct metal-to-metal connections and/or via wired or soldered connections) and electrically connected to the input DC busbar (e.g., first lower busbar 416a) through an electrical connector, such as a via (e.g., electrical connectors 1302) formed through the primary substrate 402, as illustrated in FIG. 13A. Similarly, the second power switch 514(DC-) can be directly electrically connected to the corresponding portion of the primary winding 408, that is subsection A (e.g., via direct metal-to-metal connections and/or via wired or soldered connections) and electrically connected to the output DC busbar (e.g., second lower 416b) through an electrical connector, such as a via (e.g., electrical connectors 1302) form through the primary substrate 402, in the same manner as illustrated with respect to the perspective illustrated in FIG. 13A.

In accordance with this configuration, the primary side forward and reverses current flows of the DCDC converter travel vertically through the respective power switches 514(DC+) and 515(DC-) between the corresponding DC input and output busbars and subsection A primary winding over the shortest possible distance vertical defined by the thickness of the primary substrate 402, thereby minimizing switching losses and optimizing the efficiency of the DCDC converter. As described with reference to FIG. 3, the switching on and of these primary side DCDC switches (e.g., 514(DC+) and 514(DC-) can be controlled via the main controller 314, which correspond to main DCDC controller 412 positioned on the top surface of the primary substrate 402. The main DCDC controller 412 can be electrically connected to switches 514(DC+) and 515(DC-) via traces (not shown) formed on or within the primary substrate 402 and/or using vias (e.g., when formed on the opposite side of the substrate), wires or other suitable PCB connective technologies.

Various alternative yet similar arrangements of the primary side DCDC switches 514(DC+) and 514(DC-) relative to the DC input and output busbars and the primary winding are also envisioned. For example, in some embodiments, alternative to placing the first switch 514(DC+) and the second switch 514(DC-) on the top surface 402A of the primary substrate 402, one or both of these switches may be positioned at mirrored locations relative to that illustrated in FIG. 6 and FIG. 10B on the bottom surface 402B of the primary substrate 402. For example, as illustrated in FIG. 5B and FIG. 8, and FIG. 10A, in some embodiments, the first switch 514(DC+) can be located on the top surface of the primary substrate 402 and aligned with the DC input busbar (e.g., first lower busbar 416a), and the second switch 514(DC-) can be located on the bottom surface 402B of the primary substrate 402 and aligned with the DC output busbar (e.g., second lower busbar 416b). Still in other embodiments, both the first switch 514(DC+) and the second switch 514(DC-) can be located on the bottom surface 402B of the primary substrate 402. In accordance with all of these configurations, the primary side forward and reverse current flows still adhere to the vertical current flow paths described above.

The primary side electrical components of the DCDC converter can further include capacitors 702c corresponding to capacitor 316a and capacitors 702b corresponding to capacitor 316b. As described with reference to FIG. 3, these capacitors 702c and/or 702b can include or correspond to the resonance bank of the DCDC converter 300 which temporarily store electrical current generated by the transformer in accordance with the forward or positive current flow paths. The location of these capacitors 702c and 702b relative to the primary winding 408 is also of particular importance and uniquely configured to afford specific functional advantages. In particular, as described with reference to FIG. 3, in accordance with the primary side forward or positive current flow, the electrical current is received by the capacitors 316a and 316b from the primary winding 308 and temporarily stored. Likewise, in accordance with the primary side reverse or negative current flow, the electrical current is released from the capacitors 316a and 316b sent back through the primary winding 308.

To this end, as shown in FIGs. 9, 10A, 10B, 13A and 13B, capacitors 702b and 702c, which respectively correspond to capacitors 316a and 316b, can collectively be positioned in a row or straight line and directly below and along the width (e.g., along axis Z-Z') of subsection C of primary winding 408. As illustrated in FIGs. 7, 8, 9, 13A and 13B, these capacitors 702c and 702b can be positioned on the bottom surface 402B of the primary substrate 402, laterally between substrate 502 comprising the secondary winding 504 and the lower busbars (e.g., first lower busbar 416a and second lower busbar 416b). With this configuration, capacitors 702c and capacitors 702b are positioned directly below and aligned with subsection C of primary winding 408 as positioned on the opposite surface (e.g., top surface 402A) of the primary substrate 402. Capacitors 702c and 702b can further be directly connected to subsection C of the primary winding 408 via one or more electrical connectors 1302 formed through the thickness of the primary substrate 402, as shown in FIGs. 13A and 13B (and/or via another suitable electrical connection mechanism). With this configuration, the current path between the subsection C of primary winding 408 and the resonance capacitors 702b and 702c is vertical through the primary substrate 402, and thus the shortest possible current path (e.g., defined only by the vertical thickness of the primary substrate 402) is achieved between the primary winding 408 and the resonance bank capacitors 702c and 702b, thereby improving the efficiency of the DCDC converter and minimizing switching losses.

Similarly, the secondary side (or rectification side) elements of the DCDC converter of the PCB device 400 are intelligently integrated on opposite surfaces (e.g., the top surface 402A and the bottom surface 402B) on the distal end of the primary substrate 402. In particular, as illustrated in FIGs. 9, 10A, 10B, 13A and 13B, the secondary side DC positive output connection 404 (e.g., corresponding to positive output connection 324a), the secondary side negative output connection 406 (corresponding to negative output connection 324b) and the rectification controller 407 (corresponding to rectification controller 320) can be positioned on the top surface 402A of the primary substrate 402 at positions directly above (and thus vertically aligned with) capacitors 702d corresponding to the secondary side capacitor 322 of DCDC converter 300. As described with reference to FIG. 3, the secondary side capacitor 322, which corresponds to the group of capacitors 702d, can function as a rectification filter of the DCDC converter 300 through which the secondary side input and output currents are filtered prior to being transferred to the load 326 via the positive output connection 324a (corresponding to positive output connection 404) or the negative output connection 324b (corresponding to negative output connection 406) or the ground. With this configuration, the positive output connection 404 can and the negative output connection 406 can be directly and vertically connected to the capacitors 702d positioned on the opposite surface of the primary substrate 402 using one or more electrical connectors (e.g., vias 1302 as illustrated in FIGs. 13A and 13B) formed through the thickness of the primary substrate 402, again providing the shortest possible current flow distances between the respective components in the vertical direction through primary substrate 402 (e.g., defined by the thickness of the primary substrate 402). In addition, by placing these capacitors 702d laterally adjacent to the secondary winding 504 formed within substrate 502, the current flow path between the capacitors 702d and the secondary winding 504 (included in the substrate 502) is minimal, further optimizing the efficiency of the DCDC converter.

In addition, the secondary side rectification switches 704a and 704b, respectively corresponding to rectification switches 318a and 318b, which control the secondary side forward (or positive) and reverse (or negative) flows, and thus the flow of current between the secondary winding 504 and the capacitors 702d, are intelligently positioned on the bottom surface 402B of the primary substrate 402 on opposite sides of capacitors 702b in the Z-Z' direction. In other words, the capacitors 702d are positioned between the positive and negative rectification switches 704a and 704b and very close to the secondary winding 504. With this configuration, the current flow path between the secondary winding 504, the rectification switches 704a and 704b and the rectification capacitors 702d is minimal, thereby minimizing switching losses and improving efficiency of the DCDC converter. The secondary winding 504, the rectification switches 704a and 704b and the rectification capacitors 702d can be electrically connected to one another via traces formed on the bottom surface 402B of the primary substrate, electrical wires, or another suitable connection mechanism. The rectification controller 407 which can control the switching of the rectification switches 704a and 704b (in embodiments in which they include or correspond to MOSFETs as opposed to diodes) is further positioned above the position of the rectification switches 704a and 704b on the opposite surface (e.g., the top surface or top surface 402A) of the primary substrate, as illustrated in FIG. 10A, 10B, 13A and 13B (e.g., above yet between the switches 704a and 704b on the opposite surface of the primary substrate 402). The rectification controller 704 can further be electrically connected to the rectification switches 704a and 704b using vias 1302 formed through the thickness of the substrate and/or traces.

In addition, as illustrated in FIGs. 7 and 8, in some embodiments, the bottom surface 402B of the primary substrate 402 can include a row of capacitors 702a positioned laterally between the right side edge of the second lower busbar 416b and the left side edge of the first lower busbar 416a. With this configuration, the row of capacitors 702c are positioned on or within the power module of the PCB device 400 and between the plurality of power switches 514. Said differently, the row of capacitors 702b can be formed adjacent and parallel to one or more rows of power switches 514 formed on the back surface 402B and/or the top surface 402A of the PCB device 400. With this configuration, the row of capacitors 702a can be used as a snubber to soften voltage spikes or switching losses associated with switching operations of portion of the power switches 514 that are disassociated with the DCDC converter of PCB device 400.

In particular, as noted above, the power module of the PCB device 400 can include a plurality of power 514 switches and only two (or in some implementations four) of these power switches 514 are used as the primary side DCDC switches (e.g., 514(DC+) and 514(DC-). The rest (e.g., typically between 8 and 10 additional MOSFETs) of the power switches 514 are used for switching operations associated with transferring electrical current between the upper busbars (e.g., first upper busbar 414a and second upper busbar 414b). For example, these switching operations can include transferring AC electrical current between battery cell units 106 and one or more motors 112, among others. These switching operations involve transferring high voltage electrical currents between the upper busbars 414a and 414b and can generate voltage spikes and switching losses in association with switching the current flows off and on via the corresponding power switches 514. To this end, in various embodiments, the capacitors 702a can be respectively electrically connected (e.g., via electrical connectors 1302 and/or or via another suitable electrical connection mechanism) to the upper busbars 414a and 414b and/or the portion of the power switches 514 that are used for the switching operations disassociated with the DCDC converter. The capacitors 702a be further configured to receive electrical current from the upper busbars 414a and 414b (directly and/or via corresponding power switches 514) and/or supply electrical current to the upper busbars 414a and 414b (directly and/or via corresponding power switches 514) to soften voltage spikes and minimize switching losses associated with these switching operations.

In some embodiments, in addition to the function of capacitors 702a described above, the capacitors 702a may also be used as an additional primary side input voltage source for the DCDC converter of PCB device 400. In particular, as described with reference to FIG. 3, the primary side forward and reverse flows can operate at very high switching frequencies (e.g., about 100 to 200 kHz). The switching frequency of the primary side forward and reverse flows can be tailored and controlled (e.g., by the main DCDC controller 412) to achieve a desired secondary side output voltage. Generally, the higher the switching frequency, the greater the secondary side output voltage. In some embodiments in which the switching frequency is high (e.g., greater than 100 kHz), the input voltage supplied by the battery cells 202 may not be received from the input DC busbar (e.g., first lower busbar 416b) quick enough to provide the fast bursts of energy needed for the primary side forward or positive direction current flows. With these embodiments, capacitors 702a can also be configured to provide additional input current for the DCDC converter primary side forward or positive current flows. In this regard, the primary side DCDC converter input switch 515(DC+) can receive electrical input current from the capacitors 702a and supply the input current to the primary winding 408 (e.g., via subsection A) in association with the forward or positive primary side current flows.

For example, some or all of capacitors 702a can be electrically connected to subsection A of primary winding 408 via the primary side DCDC converter input switch (i.e., 514(DC+)) and/or the input DCDC busbar (i.e., first lower busbar 416a). Further, because capacitors 702a are already positioned very close to 514(DC+), the DC input busbar (e.g., first lower busbar 416a) and subsection A of primary winding 408, the current travel distance between these respective electrical components is again very minimal, thereby increasing the efficiency of the DCDC converter and minimizing switching losses. For example, as illustrated in FIGs. 7 and 8, capacitors 702a can be positioned on the bottom surface 402B of the primary substrate 402 between the lower busbars 416a and 416b in a row that extends laterally (e.g., along axis X'-X) from the proximal end of the primary substrate 402 and reaches the distal ends of the lower busbars 416a and 416b. At the same time, as shown in FIG. 8, the row of capacitors 702a extends to the distal end of the power module (wherein the power module refers to power switches 514 grouped collectively as a single unit), wherein the distal end of the power module includes the primary side DCDC power switches 514(DC-) and 514(DC+) positioned directly under subsection A of primary winding 408, either on the bottom surface 402B and/or the top surface 402A (as shown in FIGs. 6, 10A, 10B, 13A and 13B). In this regard, as shown in FIGs. 13A and 13B (and other figures) the distal end of the first lower busbar 416a (and likewise the second lower busbar 416b, as shown in FIG. 9) is positioned directly vertically below 514(DC+) and subsection A of primary winding 408. To this end, the distal end of the row of capacitors 702a positioned on the bottom surface 402B at a position directly under a portion of subsection A of primary winding 408 located on the top surface 402A, and laterally adjacent (i.e., in the Z-Z' direction) to 514(DC+), thus providing a direct channel of input additional input current to subsection A of primary winding 408 for the forward or positive current flows.

With reference now particularly to the transformer components of the DCDC converter, including the transformer core 410, the primary winding 408 and the secondary winding 504 (formed on and/or within substrate 502), the geometry, size and configuration of these components is of particular importance and uniquely configured to afford specific functional advantages.

Firstly, as illustrated in FIGs. 5A, 5B, 11A, 11B and many other figures, both the primary winding 408 and the secondary winding 504 have a planar geometry. (It is noted that substrate 502 comprising the secondary winding 504 is shown in FIGs. 11A-12D with grey fill for ease of illustration). In this regard, as described above with reference to FIGs. 5A and 5B, the secondary winding 504 can be formed out of traces that are formed on or within substrate 502 having a planar geometry. For example, substrate 502 can comprise a planar substrate formed out of one or more planar layers of insulating material and/or conductive material. The thickness of substrate 502 (e.g., in the Y-Y' direction) can vary, however in preferred embodiments, the thickness of substrate is 502 is less than 1.0 mm, more preferably less than 0.5 mm, and even more preferably less than 0.2 mm. The secondary winding 504 can be formed on and/or within substrate 502 as traces that are etched on the surface and/or embedded within the thickness of substrate 502 and patterned into a desired winding pattern with a desired number of turns.

The primary winding 408 also has a planar geometry. In various embodiments, the primary winding 408 comprises a sheet of conductive metal patterned into a planar winding configuration. For example, in some embodiments, the primary winding 408 can be formed out of a suitable conductive sheet of metal (e.g., copper, aluminum, gold or another suitable conductive metal) by etching and/or cutting the primary winding 408 out of a sheet of metal into the winding pattern illustrated in the Figures.

By forming the primary winding 408 and the secondary winding 504 as planar windings, as opposed to traditional coil windings, the primary winding 408, this eliminates the normal intricate winding operation required for conventional transformer designs, thus reducing manufacturing costs. For example, conventional transformer designs form the primary winding and the secondary winding as coils that are respectively wound tightly around and around separate pieces of the transformer core. In addition, by forming the primary winding 408 and the secondary winding 504 as planar components, this results in adding nominal thickness (e.g., less than 1.0 mm, preferably less than 0.5 mm, and even more preferably less than 0.3 mm) to the overall thickness of the PCB device 400 as assembled on the primary substrate 402. For example, in some embodiments, the thickness of substrate 502 can be less than 1.0 mm, preferably less than 0.5 mm, more preferably less than 0.3 mm, and even more preferably less than 0.2 mm. Similarly, the thickness of substrate the primary winding 408 can be less than 1.0 mm, preferably less than 0.5 mm, more preferably less than 0.3 mm, and even more preferably less than 0.2 mm.

Secondly, by forming the secondary winding 504 of the DCDC converter as a separate component on or within substrate 502 that can be separately attached to the bottom surface 402B of the primary substrate 402, the output voltage capabilities of the DCDC converter can be selectively and efficiently configured by changing only the configuration of the secondary winding 504. For example, the output voltage of the DCDC converter that is supplied to the load (e.g., load 326 or the like) can be tailored to generate different voltage amounts (e.g., 15V, 48V, 400V, etc.) based on the number of turns in the traces used for the secondary winding 504 as patterned on and/or within substrate 502. With this configuration, the secondary winding 504 becomes an interchangeable component that allows for efficiently creating PCB devices corresponding to PCB device 400 with different DCDC converter output voltage capabilities. The secondary side rectification system of the DCDC converter as integrated on the primary substrate 402 can further remain the same for the different variants. However, in some embodiments, in which the secondary winding 504 is configured to generate higher output voltages (e.g., greater than 15V for instance, such as up to 400V), the secondary side rectification switches 704a and 704b can be replaced with compatible diodes (e.g., as opposed to MOSFETs or similar power switches). The voltage drop across the diodes will result in neglectable losses for a 400V variant. In this regard, the output capacity of the DCDC converter of PCB device 400 can be tailored by tailoring the configuration of the secondary winding 504 and without changing the overall structure and configuration of the other electrical components of the DCDC converter.

Thirdly, the transformer of the DCDC converter can easily and efficiently (e.g., quickly and with lower costs) be assembled on the primary substrate 402 owing to the modular configuration of the primary winding 408, the secondary winding 504, and the transformer core 410. For example, as described with reference to FIGs. 5A and 5B, the transformer of the DCDC converter can be assembled on the primary substrate 402 by attaching the bottom surface of the primary winding 408 to the top surface 402A of the primary substrate 402 at a position around openings 508a and 508b, and attaching the top surface of substrate 502 comprising the secondary winding 504 to the bottom surface 402B at a position with opening 506 aligned with opening 508b. The transformer core 410 is further formed around the primary winding 408 and the secondary winding 504 as positioned on opposite surfaces of the substrate by positioning the upper portion 410a above the primary winding 408 on the top surface 402A, positioning the lower portion 410b below substrate 502, and connecting the upper portion 410a to the lower portion 410b, as described with reference to FIGs. 5A and 5B. In various embodiments, the primary winding 408 and substrate 502 can be attached to the respective opposite surfaces of the primary substrate 402 via soldering or another suitable attachment mechanism. Similarly, the upper portion 410a can be attached to the lower portion 410b via soldering or another suitable attachment mechanism.

As assembled on the primary substrate 402, the primary winding 408 and the secondary winding 504 are formed on opposite surfaces of the primary substrate 402 and sandwiched between the upper portion 410a and the lower portion 410b of the transformer core 410. To this end, as assembled, the wherein the primary winding 408, the secondary winding 504 and the primary substrate 402 form a stacked, three-layer structure comprising the primary substrate 402 sandwiched between the primary winding 408 and the secondary winding 504. With this configuration, the planar surfaces of the primary winding 408 and the secondary winding 504 are parallel to one another and physically separated or isolated from one another by the primary substrate 402. In this regard, the primary winding 408 and the secondary winding 504 are physically separated from one another by a distance in the vertical or longitudinal direction (e.g., relative to axis Y-Y') defined by the thickness of the planar, primary substrate 402. To this end, as the thickness of the primary substrate 402 is very minimal (e.g., less than 1.0mm, preferably less than 0.5mm, and even more preferably less than 0.3 mm), the primary winding 408 and the secondary winding 504 can be tightly coupled while the primary substrate 402 serves as an isolation barrier between the primary winding 408 and the secondary winding 504. The transformer core, formed out of graphite or another magnetically coupling material, further improves the magnetic coupling between the primary winding 408 and the secondary winding 504 and serves as a guide for the electrical energy generated by the transformer, which flows between the primary winding 408, the secondary winding 504 and around and around the transformer core 410. The transformer core 410, that is both upper portion 410a and the lower portion 410b, also has a substantially planar geometry (e.g., defined by planar top and bottom surfaces, with a nominal combined thickness less than 1.5 mm, preferably less than 1.0 mm, and even more preferably less than 0.5 mm, thus contributing to reduced thickness of the entirety of the PCB device 400.

Furthermore, the geometrical shape, size and configuration of the primary winding 408, the secondary winding 504, and the transformer core 410 is particularly configured to create a defined amount of leakage inductance in the transformer. In this regard, as noted above with reference to FIG. 3, in one or more embodiments, the DCDC converter can comprise an LLC converter, which belongs to the resonant class of converters. One prerequisite for these types of converters is that there is a certain amount of leakage inductance in the transformer. This inductance can create switching losses in a flyback or forward type converter. However, with a resonant DCDC converter, the leakage inductance can be used to create an oscillation at a certain eigenfrequency. By switching the converter close to this eigenfrequency frequency, the losses in the switches can be kept to a minimum and the overall efficiency very high.

Normally, with resonant LLC converters, the primary winding and the secondary winding are tightly wound around the transformer core and placed as close to one another as possible in order to have the smallest amount of leakage inductance between the primary winding and the secondary winding as possible. The defined amount of leakage inductance required to create the oscillation at the certain eigenfrequency is then secured through an extra inductor, adding size and cost to the converter. For example, with reference briefly to FIG. 3, in accordance with conventional LLC converter designs, and extra inductor (e.g., a winding or coil) with a separate core formed around it would be placed on the primary side portion of the circuit near the position of the transformer as illustrated in FIG. 3.

However, in accordance with the disclosed techniques the primary winding 408, the secondary winding 504 and the transformer core 410 are configured in such a way as to create the desired amount of leakage inductance needed to create the oscillation at the certain eigenfrequency without using an extra inductor. For example, in various embodiments, the DCDC converter of PCB device can be defined as comprising only two inductors, the primary winding 408 and the secondary winding 504, and the primary winding 408 and the secondary winding 504 are respectively configured to generate a defined amount of leakage inductance by DCDC converter as an LLC resonant converter without usage of a third inductor. As result, the cost of the DCDC converter of PCB device 400 is reduced relative to conventional LLC converters, which provides a substantial reduction in the overall cost of the smartcell battery system 102 as each battery cell unit cell 106 A1-A*n*, B1-B*n*, and C1-C*n* is coupled to a separate PCB device corresponding to PCB device 400.

In this regard, in accordance with the disclosed techniques, the defined amount of leakage inductance required for transformer is accomplished (at least in part) by using an oversized primary winding 408, by positioning the primary winding 408 relative to the secondary winding such that they are not perfectly aligned (e.g., thereby creating a tuned overlap between the respective windings) and by forming the transformer core 410 only around a portion of the primary winding and the secondary winding 504.

For example, as illustrated in FIGs. 10A, 10B and other figures, the transformer core 410 is formed only around central regions of both the primary winding 408 and the substrate 502 comprising the secondary winding 504. In this regard, the primary winding 408 can be defined by a first length (e.g., along axis X-X') that is greater than the length (e.g., along axis X-X') of the transformer core 410 and positioned relative to the transformer core 410 such that the distal and proximal ends of the primary winding 408 respectively extend laterally beyond the distal and proximal ends of the transformer core 410. Similarly, substrate 502 comprising the secondary winding 504 can be defined by a second length (e.g., along axis X-X') that is greater than the length (e.g., along axis X-X') of the transformer core 410 and positioned relative to the transformer core 410 such that the distal and proximal ends of substrate 502 respectively extend laterally beyond the distal and proximal ends of the transformer core 410. In this regard, the transformer core 410, having a shorter length than the primary winding 508 and the substrate 502, positioned around the primary winding 508 and the substrate 502 such that the length of the transformer core 410 is centered (or substantially centered) relative to the lengths of the primary winding 408 and the substrate 502. Said differently, the transformer core 410 can be defined by a distal end, a proximal end opposite the distal end, and a length that extends laterally from the distal end to the proximal end, and wherein portions of the primary winding 408 and the secondary winding 504 extend laterally beyond the proximal end and distal end of the transformer core 410 in a direction parallel to the first surface 402A and the second surface 402B of the primary substrate 402.

As illustrated in FIGs. 10A, 10B and other figures, the length of the transformer core 410 can be significantly less than the lengths of the primary winding 408 and the substrate 502 such that the amounts of the primary winding 408 and the secondary winding which extend laterally relative to the proximal and distal ends of the transformer core 410 is significant. For example, in some embodiments, the length of the transformer core 410 can be about 30% less than the length of the primary winding 408 and/or the substrate 502. In other embodiments, the length of the transformer core 410 can be about 40% less than the length of the primary winding 408 and/or the substrate 502. In another embodiment, the length of the transformer core 410 can be about 50% less than the length of the primary winding 408 and/or the substrate 502. In yet another embodiment, the length of the transformer core 410 can be about 60% less than the length of the primary winding 408 and/or the substrate 502.

In addition, the defined amount of leakage inductance can be created as a result of the primary winding 408 and the secondary winding 504 being partially misaligned in a direction parallel to the first surface 402A and the second surface 402B as assembled relative to one another on respective surfaces of the primary substrate. For example, in some embodiments, the lengths of the primary winding 408 and the substrate 502 (and thus the secondary winding 504 formed therein/thereon) can also be different, which results in the primary winding 408 and the secondary winding 504 not being perfectly aligned as assembled on the primary substrate 502. For example, FIGs. 11A and 11B illustrate isolated views of the primary winding 408 and the substrate 502 as positioned relative to one another as they are assembled on the primary substrate 402 in accordance with one or more embodiments. As shown in FIGs. 11A and 11B, the primary winding 408 is longer in length relative to the length of substrate 502. The primary winding 408 is further positioned relative to the substrate such that the proximal end of the primary winding 408, including at least a portion of subsection C and the entirety of subsection A, extends laterally (e.g., along axis X-X') beyond the proximal end of substrate 502. With this configuration, the primary winding 408 can be considered oversized and not perfectly aligned with substrate 502.

It should be appreciated that the actual dimensions (e.g., respective lengths (e.g., relative to axis X-X') and widths (e.g., relative to axis Z-Z')) of the primary winding 408, the substrate 502 comprising the secondary winding 504 and the transformer core 410, can vary and be tailored in accordance with the configurations illustrated in the Figures and the principles disclosed herein.

In some embodiments, as illustrated in FIGs. 11A and 11B, the distal ends and the left and right side edges of the primary winding 408 and substrate 502 may be perfectly vertically aligned. However, in other embodiments, the distal ends and/or the left and right side edges of the primary winding 408 and substrate 502 may be vertically offset from one another (i.e., not perfectly aligned), which can further facilitate creating the target amount of leakage inductance desired for the transformer. For example, FIGs. 12A-12D present various different relative configurations of the primary winding 408 and the substrate 502 that may be used. In addition to the relative sizing and lateral positioning of the primary winding 408 relative to substrate 502, in some embodiments, the vertical separation distance between the primary winding 408 and the substrate 502 can be tailored as function of the thickness of the primary substrate 402 and/or the soldering materials used to solder the respective components the opposite surfaces of the primary substrate 402 to control generation of a defined amount of leakage inductance by the DCDC converter without usage of an extra (i.e., third) inductor.

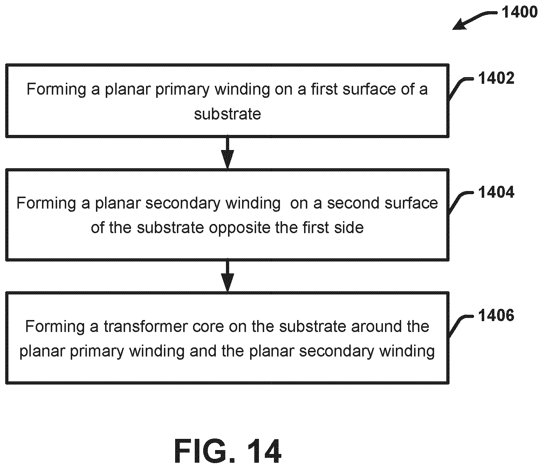

FIG. 14 illustrates an example method 1400 for forming a compact DCDC converter on a PCB device (e.g., PCB device 400) in accordance with one or more embodiments described herein. Method 1400 comprises, at 1402, forming a planar primary winding (e.g., primary winding 408) on a first surface (e.g., top surface 402A) of a substrate (e.g., primary substrate 402). At 1404, method 1400 comprises forming a planar secondary winding (e.g., secondary winding 504) on a second surface (e.g., bottom surface 402B) of the substrate opposite the first surface. At 1406, method 1400 further comprises forming a transformer core (e.g., transformer core 410) on the substrate around the planar primary winding and the planar secondary winding.

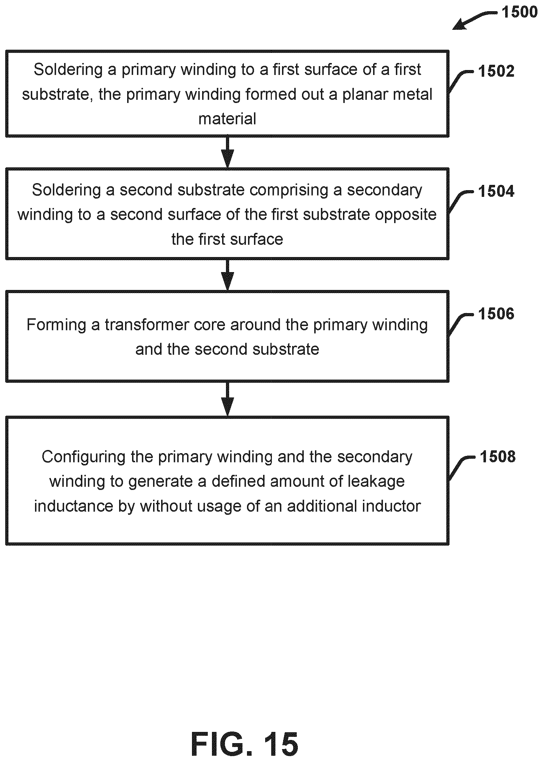

FIG. 15 illustrates another example method 1500 for forming a compact DCDC converter on a PCB device (e.g., PCB device 400) in accordance with one or more embodiments described herein. Method 1500 comprise, at 1502, soldering a primary winding (e.g., primary winding 408) to a first surface (e.g., top surface 402A) of a first substrate (e.g., primary substrate 402), the primary winding formed out a planar metal material (e.g., a suitable conductive metal such as copper, aluminum, gold, and/or another thermally conductive metal material). At 1504, method 1500 further comprises soldering a second substrate (e.g., substrate 502) comprising a secondary winding (e.g., secondary winding 504) to a second surface (e.g., bottom surface 402B) of the first substrate opposite the first surface. At 1506, method 1500 comprises forming a transformer core (e.g., transformer core 410) around the primary winding and the second substrate. At 1508, method 1500 further comprises configuring the primary winding and the secondary winding to generate a defined amount of leakage inductance by without usage of an additional inductor.

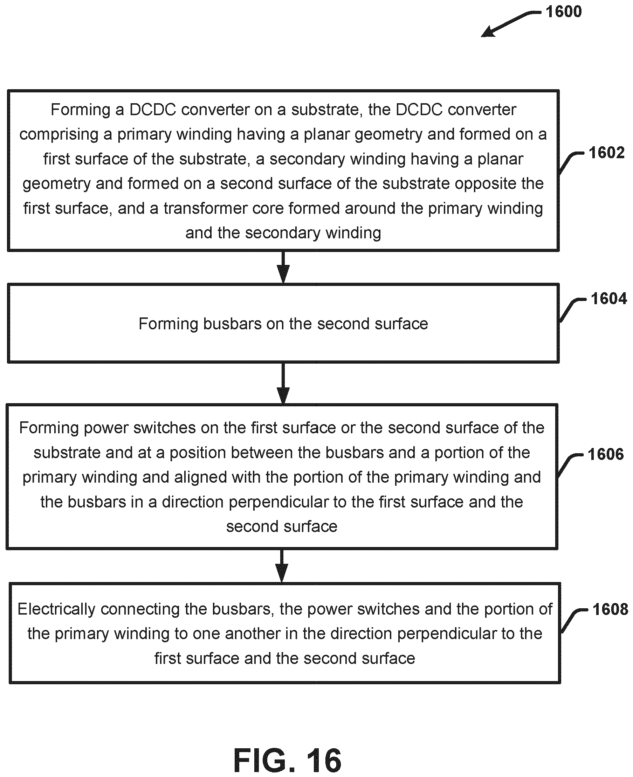

FIG. 16 illustrates another example method 1600 for forming a compact DCDC converter on a PCB device (e.g., PCB device 400) in accordance with one or more embodiments described herein. Method 1600 comprises, at 1602, forming a DCDC converter on a substrate (e.g., primary substrate 402), the DCDC converter comprising a primary winding having a planar geometry and formed on a first surface of the substrate, a secondary winding having a planar geometry and formed on a second surface of the substrate opposite the first surface, and a transformer core formed around the primary winding and the secondary winding. At 1604, method 1600 further comprises forming busbars on the second surface (e.g., lower busbars 416a/416b). At 1606, method 1600 comprises forming power switches (e.g., 514(DC+) and 514(DC-) on the first surface or the second surface of the substrate and at a position between the busbars and a portion of the primary winding and aligned with the portion of the primary winding and the busbars in a direction perpendicular to the first surface and the second surface. At 1608, method 1600 comprises electrically connecting the busbars, the power switches and the portion of the primary winding to one another in the direction perpendicular to the first surface and the second surface.

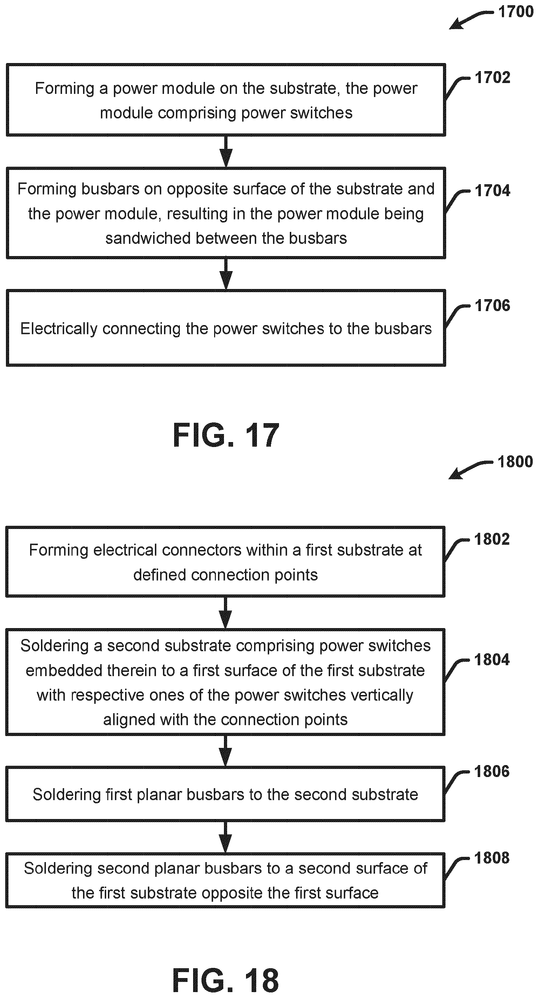

FIG. 17 illustrates an example method 1700 for forming a compact PCB device (e.g., PCB device 400) comprising an embedded power module in accordance with one or more embodiments described herein. Method 1700 comprises, at 1702, forming a power module on the substrate, the power module comprising power switches (e.g., power switches 514). At 1704, method 1700 further comprises forming busbars (e.g., upper busbars 414a/414b and lower busbars 416a/416b) on opposite surfaces of the substrate and the power module, resulting in the power module being sandwiched between the busbars. At 1706, method 1700 further comprises electrically connecting the power switches to the busbars (e.g., via electrical connectors 1302).

FIG. 18 illustrates another example method 1800 for forming a compact PCB device (e.g., PCB device 300) comprising an embedded power module in accordance with one or more embodiments described herein. Method 1800 comprises, at 1802, forming electrical connectors (e.g., electrical connectors 1302) within a first substrate (e.g., primary substrate 402) at defined connection point (e.g., connection region 516). At 1804, method 1800 comprises soldering a second substrate (e.g., substrate 512) comprising power switches (e.g., power switches 514) embedded therein to a first surface (e.g., top surface 402A and/or bottom surface 402B) of the first substrate with respective ones of the power switches vertically aligned with the connection points. At 1806, method 1800 comprises soldering first planar busbars (e.g., upper busbars 414a/414b to the second substrate. At 1808, method 1800 comprises soldering second planar busbars (e.g., lower busbars 416a/416b) to a second surface of the first substrate opposite the first surface.

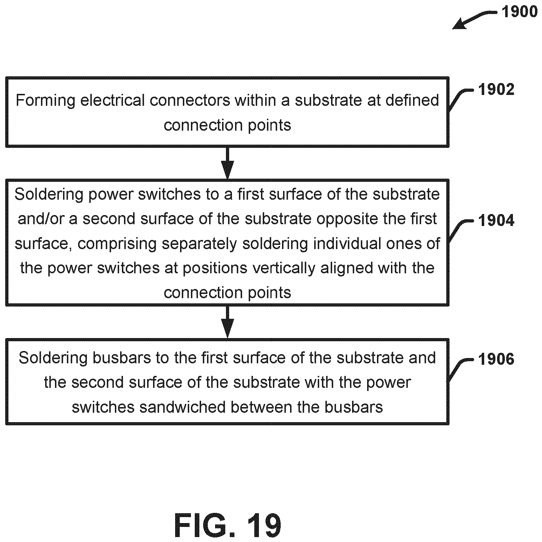

FIG. 19 illustrates another example method for forming a compact PCB device (PCB device 400) comprising an embedded power module in accordance with one or more embodiments described herein. Method 1900 comprises, at 1902, forming electrical connectors (e.g., electrical connectors 1302) within a substrate (e.g., primary substrate 402) at defined connection points (e.g., connection regions 516). At 1904, method 1490 comprises soldering power switches (e.g., power switches 514) to a first surface (e.g., top surface 402A) of the substrate and/or a second surface (e.g., bottom surface 402B) of the substrate opposite the first surface, comprising separately soldering individual ones of the power switches at positions vertically aligned with the connection points. At 1906, method 1900 comprises soldering busbars (e.g., upper busbars 414a/414b and lower busbars 416a/416b) to the first surface of the substrate and the second surface of the substrate with the power switches sandwiched between the busbars.

What has been described herein includes one or more mere examples of one or more systems and/or methods. It is, of course, not possible to describe every conceivable combination of components and/or system-implemented methods for purposes of describing the subject matter. Nonetheless, one of ordinary skill in the art can recognize that one or more further combinations and/or permutations of the disclosed subject matter are possible. Furthermore, to the extent that the terms "includes", "has", "possesses" and/or the like are used in the detailed description, claims, appendices and/or drawings, such terms are intended to be inclusive in a manner similar to the term "comprising" as "comprising" is interpreted when employed as a transitional word in a claim.

It will be understood that when an element is referred to as being "coupled" to another element, the term "coupled" can describe one or more different types of coupling including, but not limited to, chemical coupling, communicative coupling, capacitive coupling, electrical coupling, electromagnetic coupling, inductive coupling, operative coupling, optical coupling, physical coupling, thermal coupling and/or another type of coupling. As referenced herein, an "entity" can comprise a machine, device, hardware, software, computing device and/or human. Such entity can facilitate implementation of the subject matter disclosed herein in accordance with one or more embodiments described herein.

In addition, the term "or" is intended to mean an inclusive "or" rather than an exclusive "or." That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. Moreover, articles "a" and "an" as used in the subject specification and annexed drawings should generally be construed to mean "one or more" unless specified otherwise or clear from context to be directed to a singular form. As used herein, the terms "example" and/or "exemplary" are utilized to mean serving as an example, instance and/or illustration. For the avoidance of doubt, the subject matter disclosed herein is not limited by such examples. In addition, any aspect and/or design described herein as an "example" and/or "exemplary" is not necessarily to be construed as preferred and/or advantageous over other aspects or designs, nor is it meant to preclude equivalent exemplary structures and/or techniques known to those of ordinary skill in the art.

The description of the one or more various embodiments provided herein has been presented for purposes of illustration but is not intended to be exhaustive and/or limited to the one or more embodiments disclosed. One or more modifications and/or variations will be apparent to those of ordinary skill in the art without departing from the scope and/or spirit of the described embodiments. The terminology used herein was chosen to best explain the principles of the embodiments, practical application and/or technical improvement over technologies found in the marketplace, and/or to enable others of ordinary skill in the art to understand the embodiments disclosed herein.

What has been described above include mere examples of systems and computer-implemented methods. It is, of course, not possible to describe every conceivable combination of components or computer-implemented methods for purposes of describing this disclosure, but one of ordinary skill in the art can recognize that many further combinations and permutations of this disclosure are possible. Furthermore, to the extent that the terms "includes," "has," "possesses," and the like are used in the detailed description, claims, appendices and drawings such terms are intended to be inclusive in a manner similar to the term "comprising" as "comprising" is interpreted when employed as a transitional word in a claim. The descriptions of the various embodiments have been presented for purposes of illustration, but are not intended to be exhaustive or limited to the embodiments disclosed. Many modifications and variations can be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

Various non-limiting aspects of various embodiments described herein are presented in the following clauses.
1. A printed circuit board (PCB) device, comprising:
   busbars formed on opposite surfaces of a substrate; and
   a power module formed on the substrate sandwiched between the busbars and electrically connected to the busbars, the power module comprising power switches that control flow of an electrical current between the busbars.
2. The PCB of clause 1, wherein the power switches are directly electrically connected to the busbars.
3. The PCB of clause 1, wherein the power switches control the flow of the electrical current in a direction perpendicular to the opposite surfaces of the substrate.
4. The PCB of clause 1, wherein the substrate comprises electrical connectors formed within a thickness of the substrate and exposed on the opposite surfaces of the substrate, wherein the power switches are formed on the substrate at positions directly above or directly below the electrical connectors, and wherein the electrical connectors connect respective ones of the power switches to the busbars.
5. The PCB of clause 4, wherein the substrate comprises a first substrate, wherein the power module comprises a second substrate comprising the power switches embedded within the second substrate, and wherein the second substrate is soldered to the first substrate.
6. The PCB of clause 5, wherein each of the power switches comprise drain and source components, and wherein the drain and source components are exposed on opposite surfaces of the second substrate.
7. The PCB of clause 1, wherein at least some of the power switches are individually soldered to the substrate.
8. The PCB of clause 1, wherein the PCB device comprises a planar geometry defined by a thickness of about 1.5 millimeters or less.
9. A method, comprising:
   forming a power module on the substrate, the power module comprising power switches;
   forming busbars on opposite surfaces of the substrate and the power module; and
   electrically connecting the power switches to the busbars.
10. The method of clause 9, wherein forming the busbars comprises soldering the busbars to the opposite surfaces of the substrate with the power module sandwiched between the busbars.
11. The method of clause 9, further comprising:
   forming electrical connectors within a thickness of the substrate and exposed on the opposite surfaces of the substrate, and wherein forming the power module comprises positioning the power switches on the substrate at positions directly above or directly below the electrical connectors.
12. The method of clause 11, wherein the substrate comprises a first substrate, wherein the power module comprises the power switches embedded within a second substrate, and wherein forming the power module on the substrate comprises soldering the second substrate to first substrate.
13. The method of clause 12, wherein soldering the second substrate to the first substrate comprises soldering the second substrate to a first surface of the first substrate, and wherein forming the busbars comprises:
   soldering one or more first busbars to the second substrate; and
   soldering one or more second busbars to a second surface of the first substrate opposite the first surface.
14. The method of clause 11, wherein forming the power module comprises separately soldering at least some of the power switches to the substrate.
15. A device, comprising:
   one or more battery cells; and
   a printed circuit board (PCB) device attached to the one or more battery cells, the PCB device comprising:
      busbars formed on opposite surfaces of a substrate, wherein at least one of the busbars is electrically connected to the one or more battery cells; and
   a power module formed on the substrate sandwiched between the busbars and electrically connected to the busbars, the power module comprising power switches that control flow of an electrical current between the busbars.
16. The device of clause 15, wherein the power switches control the flow of the electrical current in a direction perpendicular to the opposite surfaces of the substrate.
17. The device of clause 15, wherein the substrate comprises electrical connectors formed within a thickness of the substrate and exposed on the opposite surfaces of the substrate, wherein the power switches are formed on the substrate at positions directly above or directly below the electrical connectors, and wherein the electrical connectors connect respective ones of the power switches to the busbars.
18. The device of clause 17, wherein the substrate comprises a first substrate, wherein the power module comprises a second substrate comprising the power switches embedded within the second substrate, and wherein the second substrate is soldered to the first substrate.
19. The device of clause 17, wherein at least some of the power switches are individually soldered to the substrate.
20. The device of clause 15, wherein the PCB device comprises a planar geometry defined by a thickness of about 1.5 millimeters or less.

## Claims

1. A printed circuit board (PCB) device, comprising:
busbars formed on opposite surfaces of a substrate; and
a power module formed on the substrate sandwiched between the busbars and electrically connected to the busbars, the power module comprising power switches that control flow of an electrical current between the busbars.

2. The PCB of claim 1, wherein the power switches are directly electrically connected to the busbars.

3. The PCB of claim 1, wherein the power switches control the flow of the electrical current in a direction perpendicular to the opposite surfaces of the substrate.

4. The PCB of claim 1, wherein the substrate comprises electrical connectors formed within a thickness of the substrate and exposed on the opposite surfaces of the substrate, wherein the power switches are formed on the substrate at positions directly above or directly below the electrical connectors, and wherein the electrical connectors connect respective ones of the power switches to the busbars.

5. The PCB of claim 4, wherein the substrate comprises a first substrate, wherein the power module comprises a second substrate comprising the power switches embedded within the second substrate, and wherein the second substrate is soldered to the first substrate.

6. The PCB of claim 5, wherein each of the power switches comprise drain and source components, and wherein the drain and source components are exposed on opposite surfaces of the second substrate.

7. The PCB of claim 1, wherein at least some of the power switches are individually soldered to the substrate.

8. The PCB of claim 1, wherein the PCB device comprises a planar geometry defined by a thickness of about 1.5 millimeters or less.

9. A method, comprising:
forming a power module on the substrate, the power module comprising power switches;
forming busbars on opposite surfaces of the substrate and the power module; and
electrically connecting the power switches to the busbars.

10. The method of claim 9, wherein forming the busbars comprises soldering the busbars to the opposite surfaces of the substrate with the power module sandwiched between the busbars.

11. The method of claim 9, further comprising:
forming electrical connectors within a thickness of the substrate and exposed on the opposite surfaces of the substrate, and wherein forming the power module comprises positioning the power switches on the substrate at positions directly above or directly below the electrical connectors.

12. The method of claim 11, wherein the substrate comprises a first substrate, wherein the power module comprises the power switches embedded within a second substrate, and wherein forming the power module on the substrate comprises soldering the second substrate to first substrate.

13. The method of claim 12, wherein soldering the second substrate to the first substrate comprises soldering the second substrate to a first surface of the first substrate, and wherein forming the busbars comprises:
soldering one or more first busbars to the second substrate; and
soldering one or more second busbars to a second surface of the first substrate opposite the first surface.

14. The method of claim 11, wherein forming the power module comprises separately soldering at least some of the power switches to the substrate.

15. A device, comprising:
one or more battery cells; and
a printed circuit board (PCB) device attached to the one or more battery cells, the PCB device comprising:
busbars formed on opposite surfaces of a substrate, wherein at least one of the busbars is electrically connected to the one or more battery cells; and
a power module formed on the substrate sandwiched between the busbars and electrically connected to the busbars, the power module comprising power switches that control flow of an electrical current between the busbars.
